(19) Europäisches Patentamt / European Patent Office / Office européen des brevets

(11) **EP 3 123 824 B1**

(12) **EUROPÄISCHE PATENTSCHRIFT**

(45) Veröffentlichungstag und Bekanntmachung des Hinweises auf die Patenterteilung:
01.07.2020 Patentblatt 2020/27

(21) Anmeldenummer: **15712300.1**

(22) Anmeldetag: **17.03.2015**

(51) Int Cl.:
*F21K 9/00* *(2016.01)*　　*F21S 4/00* *(2016.01)*
*F21K 9/64* *(2016.01)*　　*F21Y 103/00* *(2016.01)*
*F21V 5/04* *(2006.01)*　　*H05B 45/00* *(2020.01)*
*H05B 45/20* *(2020.01)*　　*H05B 45/40* *(2020.01)*
*F21Y 103/10* *(2016.01)*　　*F21Y 115/10* *(2016.01)*
*F21Y 113/13* *(2016.01)*

(86) Internationale Anmeldenummer:
**PCT/EP2015/055540**

(87) Internationale Veröffentlichungsnummer:
**WO 2015/144493 (01.10.2015 Gazette 2015/39)**

(54) **BELEUCHTUNGSVORRICHTUNG ZUR ERZEUGUNG VON WEISSEM LICHT**

LIGHTING DEVICE FOR GENERATING WHITE LIGHT

DISPOSITIF D'ÉCLAIRAGE SERVANT À PRODUIRE DE LA LUMIÈRE BLANCHE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.03.2014 DE 202014101445 U**
**03.07.2014 DE 202014103047 U**

(43) Veröffentlichungstag der Anmeldung:
**01.02.2017 Patentblatt 2017/05**

(73) Patentinhaber: **Tridonic GmbH & Co. KG**
**6850 Dornbirn (AT)**

(72) Erfinder: **DOBOS, Janos**
**H-9700 Szombathely (HU)**

(74) Vertreter: **Rupp, Christian**
**Mitscherlich PartmbB**
**Patent- und Rechtsanwälte**
**Sonnenstraße 33**
**80331 München (DE)**

(56) Entgegenhaltungen:
**WO-A2-2012/104800　US-A1- 2003 223 235**
**US-A1- 2005 135 094　US-A1- 2010 172 152**
**US-A1- 2010 296 269　US-A1- 2010 327 229**
**US-A1- 2011 031 894　US-A1- 2011 205 727**
**US-A1- 2012 300 452　US-A1- 2013 141 908**

**Beschreibung**

Die vorliegende Erfindung betrifft eine Beleuchtungsvorrichtung (1) zur Erzeugung von weißem Licht, die wenigstens einen Streifen aus drei Leuchtdioden (LEDs) (2) in einer linearen Anordnung aufweist, wobei:

a) jeder LED-Streifen (2) zwei äußere LEDs (3) und eine mittlere LED (4) aufweist;
b) jede der äußeren LEDs (3) und die mittlere LED (4) phosphorkonvertierte weiße LEDs sind; und
c) der Abstand jeder der Farbkoordinaten der zwei äußeren LEDs zu der Farbkoordinate des Mischlichts der zwei äußeren LEDs und der mittleren LED kleiner als der Abstand der Farbkoordinate der mittleren LED zu den Farbkoordinaten des Mischlichts der zwei äußeren LEDs und der mittleren LED ist.

Phosphorkonvertierte Dioden (LEDs), die weißes Licht emittieren, wie sie während eines Herstellungsverfahrens erhalten werden, stellen typischerweise Farbtemperaturen und Farbkoordinaten bereit, die sich nicht nur von Charge zu Charge, sondern auch von LED zu LED unterscheiden. Dies erfordert wiederum eine Klassifikation derartiger LEDs nach ihrer Herstellung im Hinblick auf Farbtemperaturen und Farbkoordinaten, bevor derartige LEDs in einer Beleuchtungsvorrichtung verwendet werden. Eine derartige Klassifizierung ermöglicht es einem Fachmann typischerweise, LEDs mit einer ähnlichen oder identischen Klassifikation geeignet auszuwählen, um sicherzustellen, dass ein homogenes weißes Licht mit einer definierten Farbtemperatur und Farbkoordinate ausgegeben wird.

Die Klassifikation von LEDs wird typischerweise unter Verwendung eines Binning-Verfahrens ausgeführt, gemäß dem die Chromatizität und insbesondere die Farbkoordinaten und Farbtemperaturen der LEDs einer oder mehrerer Herstellungsschargen bestimmt und dann nach einem vorgegebenen Klassifikationssystem klassifiziert werden. Normalerweise bestehen derartige vorgegebene Klassifikationssysteme aus vordefinierten Regionen, z.B. aus Bins und Sub-Bins, in welche die LEDs gemäß ihrer Farbtemperatur und Farbkoordinate einsortiert werden. Ein beispielhaftes Klassifikationssystem ist die ANSI-Bin-Kurve (ANSI C78.377-2008). In der ANSI-Bin-Kurve (ANSI C78.377-2008) sind Bins und Sub-Bins in der Region um die Plancksche Kurve (Schwarzkörperkurve) herum angeordnet und weisen typischerweise z.B. Bins von 0, 1, 2, 3, 4, 5, 6, 7, 8, 9, etc. auf, wobei jeder Bin in Sub-Bins unterteilt ist, z.B. ist der Bin 5 weiter in Sub-Bins 5A, 5B, 5C, 5D, etc. und sogar weiter in Sub-Bins 5A1, 5A2, 5A3, 5A4, 5B1, 5B2, 5B3, 5B4, 5C1, 5C2, 5C3, 5C4, 5D1, 5D2, 5D3, etc. unterteilt.

Die Auswahl von LEDs aus derartigen Bins und Sub-Bins findet typischerweise gemäß Vorlieben des Benutzers aufgrund ihrer Farbtemperaturen und Farbkoordinaten statt, um ein homogenes weißes Licht mit wenigen Abweichungen in der Farbtemperatur und Farbkoordinate sicherzustellen. Dies ist jedoch eine schwierige Aufgabe, wenn sowohl die Kosteneffizienz als auch die am besten geeigneten oder gewünschten Farbtemperaturen oder Farbkoordinaten für eine gewisse Lichtausgabe beachtet werden, und um eine gewisse Farbtoleranz hinsichtlich verschiedener weißer Lichtemissionen sicherzustellen.

Folglich werden LEDs von verschiedenen Bins oder Sub-Bins typischerweise miteinander kombiniert, um auch eine gewisse Toleranz in der Farbtemperatur und den Farbkoordinaten zu erreichen. Jedoch können große Farbtoleranzen nur erreicht werden, indem spezifisch ausgewählte Bins oder sogar einzelne Bins für alle LEDs ausgewählt werden, was eine Selektion passender Bins teuer machen kann. Ebenso können gekreuzte Bins für alle LEDs verwendet werden, was jedoch die Selektion wiederum teuer macht und keine großen Farbtoleranzen bereitstellt. Außerdem kann dann keine große Menge an Bins von einer Herstellungscharge verwendet werden, was ein erheblicher Faktor hinsichtlich Kosten ist.

Gemäß einer Möglichkeit, dieses Problem zu überwinden, können das ausgegebene Licht und auch die Farbtemperatur und die Farbkoordinate von LEDs von ausgewählten Bins und Sub-Bins moduliert werden, um die Farbtemperatur und die Farbkoordinate der der restlichen LEDs weiter anzupassen. Diese Möglichkeit hat den Vorteil, dass verschiedene Bins und Sub-Bins verwendet werden können, die sich nicht notwendigerweise dicht aneinander befinden. Als ein Beispiel können kalte weiße und warme weiße LEDs in einem Beleuchtungselement kombiniert werden. Jedoch erfordert eine derartige Auswahl typischerweise, dass die aktive Modulation der Lichtausgabe zu der gewünschten Farbtemperatur und Farbkoordinate gelangt. Die Modulation des erzeugten weißen Lichts kann typischerweise zu dem Zeitpunkt der Herstellung der LED oder während der Verwendung der LED ausgeführt werden.

Ein beispielhaftes Verfahren, um weißes Licht zu modulieren, ist in EP 2 253 534 A2 offenbart. Die genannte Anmeldung bezieht sich auf eine Vorrichtung und Verfahren zum Abstimmen der Farbe einer LED-basierten Lampe auf eine gewünschte Farbe oder Farbtemperatur. EP 2 253 534 A2 offenbart unter anderem eine Vorrichtung, die sowohl "warme" als auch "kalte" weiße LEDs verwendet, wobei die Lampe zu dem Zweck der Bereitstellung einer abstimmbaren Lampe LEDs umfassen kann, die zu jeder beliebigen Anzahl von "Gruppen" gehören, wobei jede Gruppe als Licht innerhalb eines anderen Farb- oder Farbtemperaturbereichs (oder eines "Bin") erzeugend definiert ist. Die Bereiche, die zu diesen verschiedenen Gruppen gehören, überlappen vorzugsweise nicht, und die gewünschte Farbe oder Farbtemperatur, auf welche die Lampe abgestimmt wird, ist irgendwo zwischen den Farben oder Farbtemperaturen, die zu den Gruppen von LEDs gehören. EP 2 253 534 A2 stellt jedoch keinerlei Anleitung bereit, wie derartige LEDs vorteilhaft ausgewählt werden können, um den zugrundeliegenden Gegenstand zu erreichen. Anstelle dessen offenbart EP 2 253 534 A2, dass kalte weiße LEDs und warme weiße LEDs, die beide immer benötigt werden, unabhängig ansprechbar sind, so dass verschiedene Ströme an die verschiedenen warmen und kalten weißen LEDs geliefert werden können und die Farbtemperatur weiter auf die gewünschten Werte moduliert wird.

Ein weiteres Verfahren zum Modulieren des weißen Lichts, wie in der Technik offenbart, ist in EP 2 378 840 A1 beschrieben. EP 2 378 840 A1 betrifft eine lichtemittierende Vorrichtung und ein Verfahren zu deren Steuerung, wobei die lichtemittierende Vorrichtung umfasst: eine Lichtquelleneinheit; einen ersten und einen zweiten optischen Erreger, der von der Lichtquelleneinheit emittierte Lichter in Lichter konvertiert, die voneinander verschiedene Farbtemperaturen und verschiedene Farbkoordinaten haben. Die Vorrichtung umfasst auch einen dritten optischen Erreger, der Licht mit einer Farbkoordinate und einer Farbtemperatur emittiert, die zu denen des von den zweiten optischen Erregern konvertierten Lichts verschieden sind. Die Vorrichtung enthält obligatorisch einen Sensor, der ein erstes Komponentensignal, ein zweites Komponentensignal und ein drittes Komponentensignal enthält, von denen jedes jeweils Lichtmengen einer ersten, einer zweiten und einer dritten Komponente des Lichts entspricht, das von dem ersten, dem zweiten und dem dritten optischen Erreger ausgegeben wird. Die Beleuchtungsvorrichtung enthält außerdem obligatorisch eine Steuerung zum Steuern der Lichtmenge der Lichtquelleneinheit, so dass eine Farbkoordinate des von dem ersten optischen Erreger, von dem zweiten optischen Erreger und von dem dritten optischen Erreger emittierten Lichts innerhalb eines Bereichs angeordnet werden, der durch die Farbkoordinaten des ersten, des zweiten und des dritten optischen Erregers gebildet wird. Die Spannungsänderungen der Leistungsversorgung modulieren dann die Lichtmenge der Lichtquelleneinheit unter der Steuerung der Steuerung, so dass die weiße Lichtausgabe und die Menge entsprechend moduliert werden können, um über eine längere Nutzungsdauer eine homogene Lichtausgabe zuzulassen.

Verfahren, wie das vorstehend offenbarte sind technisch kompliziert und erfordern gewöhnlich eine aktive Modulation der Lichtausgabe entweder vor der Herstellung der Beleuchtungsvorrichtung oder sogar über die gesamte Lebensdauer der Beleuchtungsvorrichtung. Dies erfordert eine beträchtliche Energieeingabe und lässt keine kosteffiziente Herstellung zu.

US 2005/135094 A1 offenbart eine Weißlicht-Emissionsvorrichtung, die cremefarbene Licht-Emissionsdioden verwendet. US 2011/031894 A1 offenbart eine Beleuchtungsvorrichtung, die eine erste, zweite und dritte Gruppe von Festkörper-Lichte umfasst. US 20012/300452 A1. offenbart ein LED-basiertes Beleuchtungsmodul mit bevorzugt beleuchteten farbkonvertierenden Oberflächen. WO 2012/104800 A2 offenbart eine Beleuchtungseinheit mit LED-Streifen. US 2010/296269 A1 offenbart eine Beleuchtungsvorrichtung gemäß der Präambel von Anspruch 1.

Angesichts des Vorstehenden besteht in der Technik ein Bedarf, ein einfacheres System bereitzustellen, das einer Person mit Kenntnissen der Technik erlaubt, eine Beleuchtungsvorrichtung mit einem Minimum an technischer Ausrüstung bereitzustellen, womit die Herstellungskosten klar gesenkt werden und auch die Gefahr technischer Fehler der Beleuchtungsvorrichtung über ihre gesamte Lebensdauer minimiert wird. Nichtsdestotrotz ist es auch eine Aufgabe der vorliegenden Erfindung, die kosteneffiziente Herstellung einer Beleuchtungsvorrichtung mit einer vorzugsweise über eine längere Zeit ihrer Lebensdauer oder sogar ihre gesamte Lebensdauer homogeneren Farbkoordinate und Farbtemperatur zu ermöglichen, und nichtsdestotrotz die Möglichkeit zu haben, LEDs aus verschiedenen Bins und Sub-Bins zu haben.

Kurze Beschreibung der Figuren

Die folgenden Figuren sollen die vorstehend beschriebene Erfindung detaillierter darstellen und sind nicht dazu gedacht, den Bereich der Patentansprüche darauf zu beschränken.

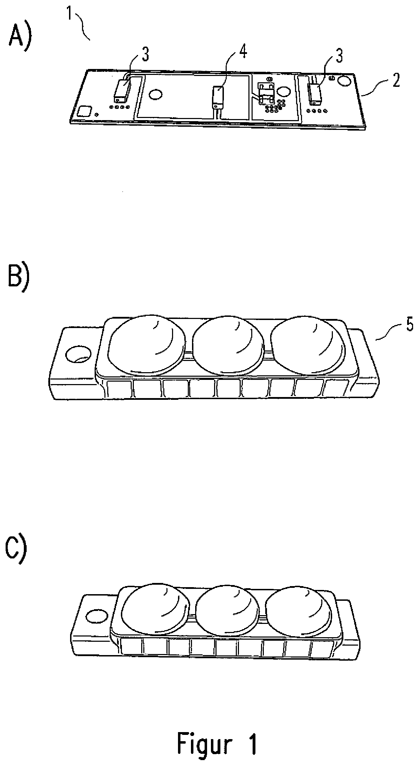

Figur 1A: zeigt eine beispielhafte erfinderische Beleuchtungsvorrichtung (1), die wenigstens einen Streifen aus drei Leuchtdioden (LEDs) in einer linearen Anordnung aufweist, wobei jeder Streifen zwei äußere LEDs (3) und eine mittlere LED (4) aufweist.

Figur 1B: zeigt eine beispielhafte Abdeckung (5) der erfinderischen Beleuchtungsvorrichtung (1).

Figur 1C: zeigt eine beispielhafte erfinderische Beleuchtungsvorrichtung (1) in Kombination mit einer beispielhaften Abdeckung (5).

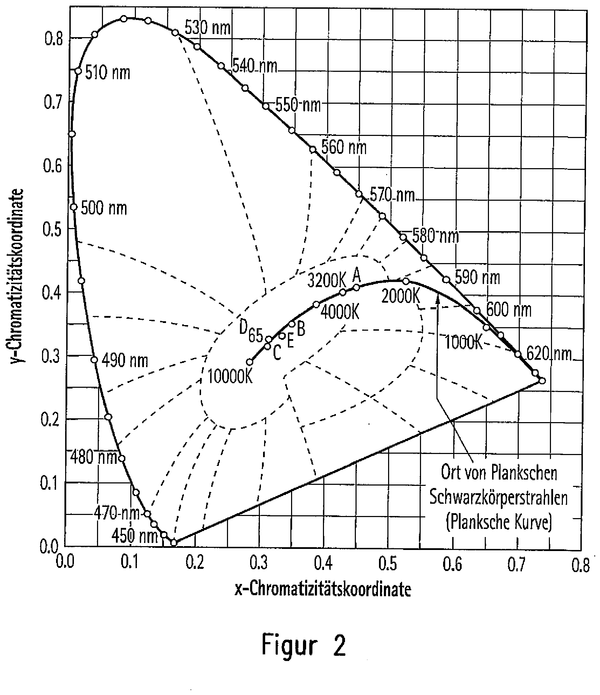

Figur 2: zeigt eine CIE-Chromatizitätsdiagrammabbildung mit einer Schwarzkörperkurve (Plancksche Kurve (Schwarzkörperkurve) nach dem 1931 CIE- (Commission internationale de l'éclairage) Farbsystem.

Figur 3: zeigt beispielhafte Bins und Sub-Bins der ANSI-Bin-Kurve (ANSI C78.377-2008). Die Bins und Sub-Bins können z.B. dem Klassifikationssystem von Cree folgend in jede Richtung erweitert und unterteilt werden.

Figur 4: zeigt beispielhafte Bins und Sub-Bins der ANSI-Bin-Kurve (ANSI C78.377-2008), wobei weitere Bins und Sub-Bins dargestellt werden.

Figur 5 bis 21: zeigen in Plänen mit den Nummern 1 bis 33 beispielhafte mögliche Kombinationen von Sub-Bins nach der ANSI-Bin-Kurve (ANSI C78.377-2008) gemäß der Erfindung, die vorzugsweise aus Kombinationen 2 bis 33 ausgewählt sind. Die gezeigten Binning-Klassen NA1 bis ND4 verallgemeinern die in Fig.3 und 4 gezeigten Sub-Bins, wobei N die jeweilige Nummer der Binning-Klasse, d.h. 0, 1, 2, 3, 4, 5, 6, 7, 8 oder 9 von Fig. 3 und 4 darstellt.

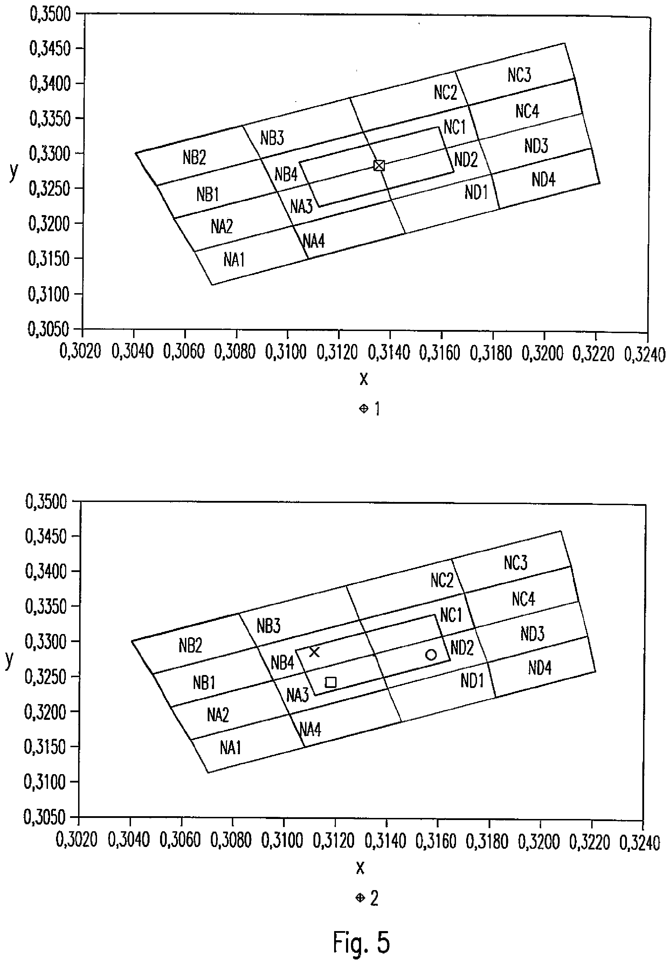

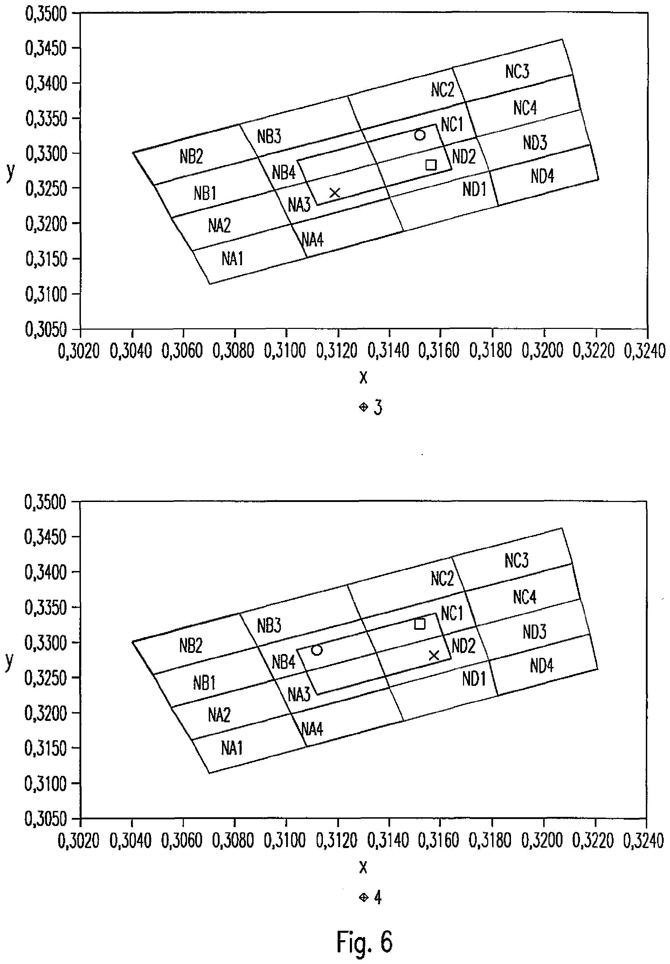

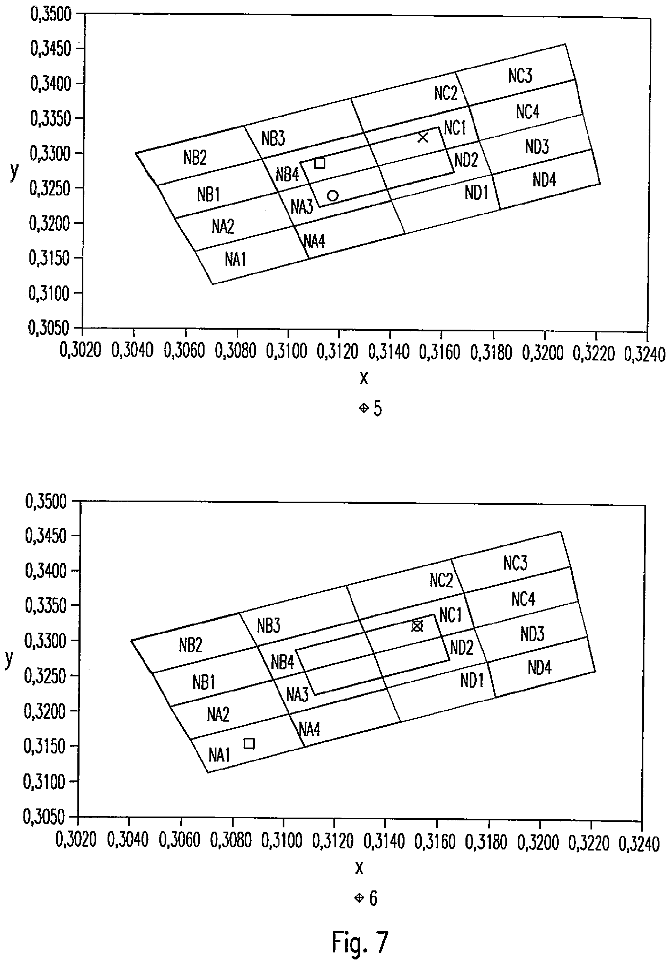

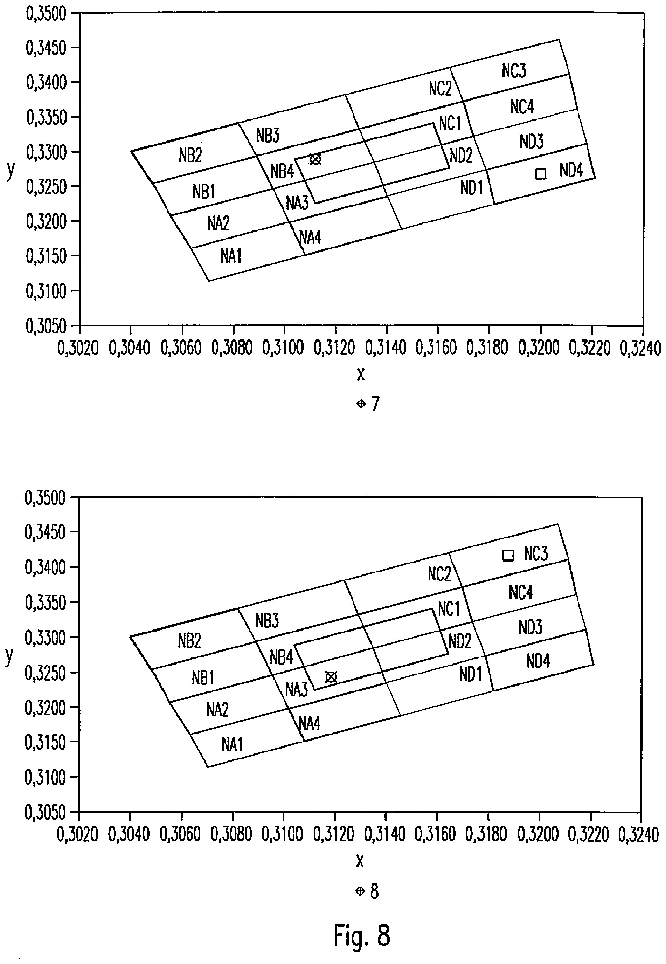

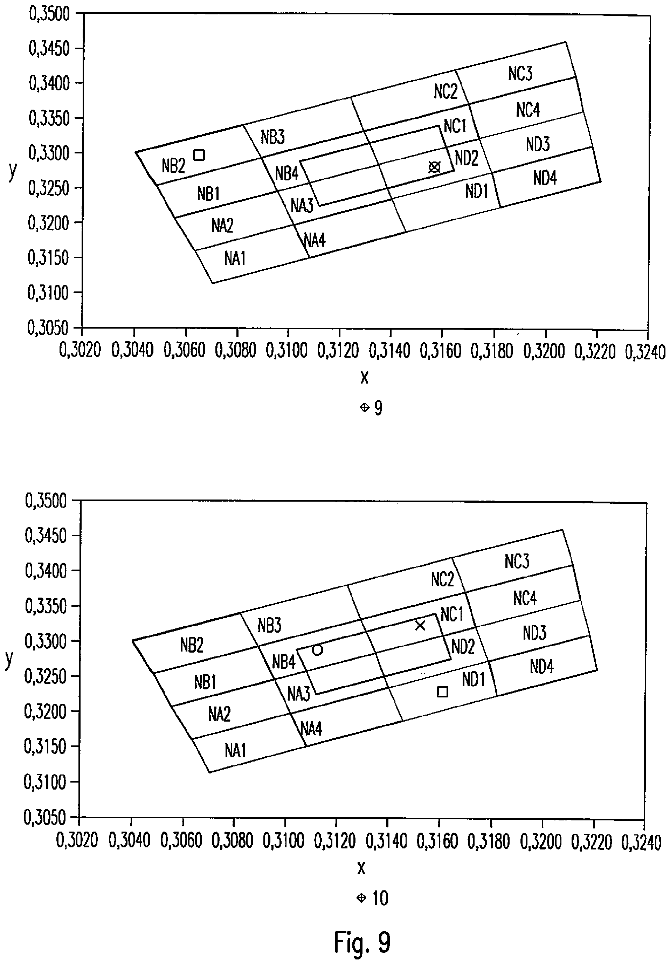

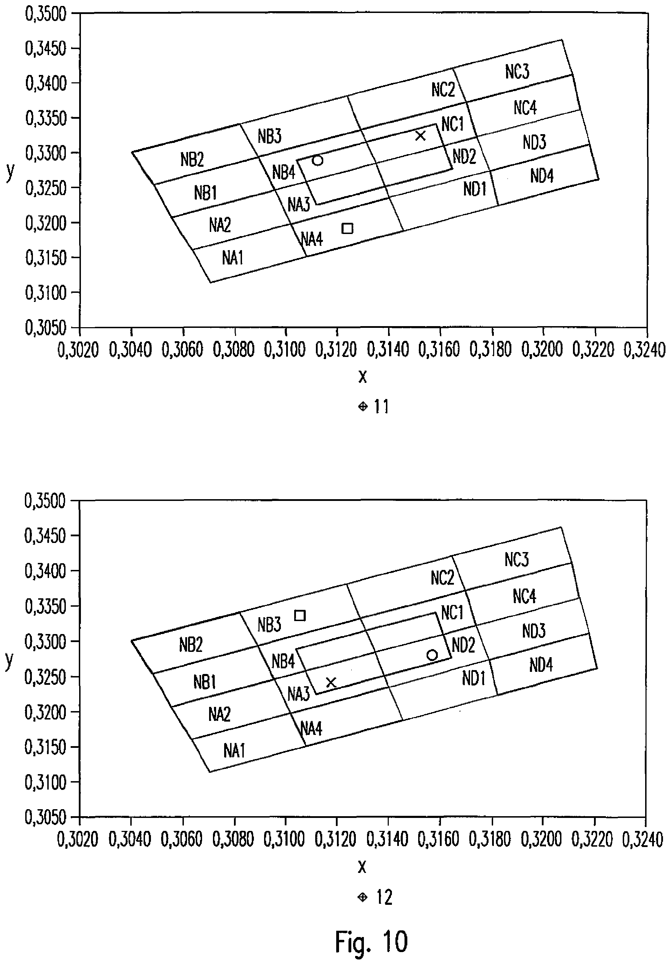

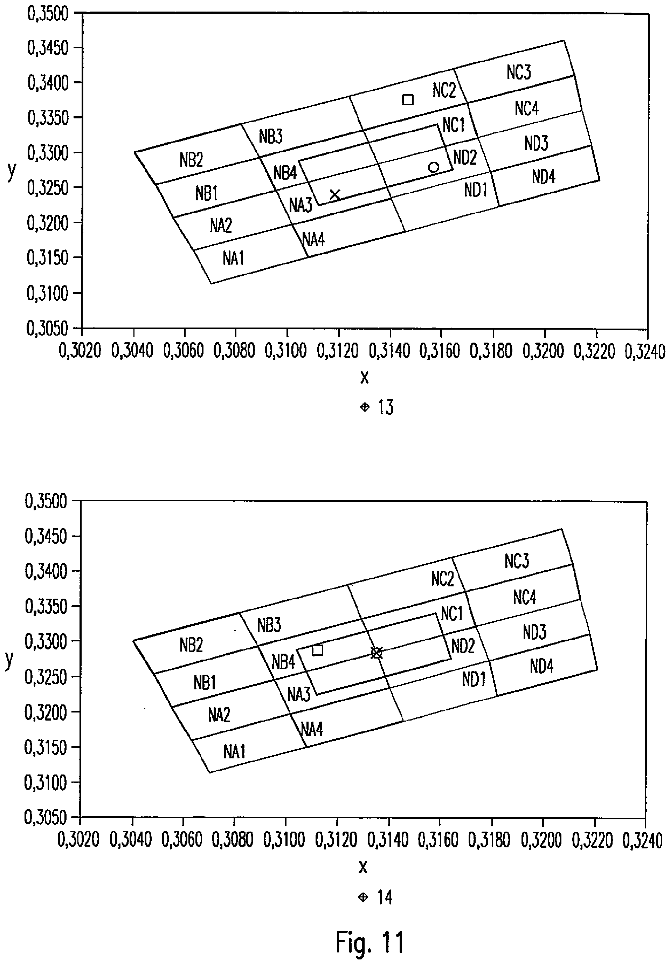

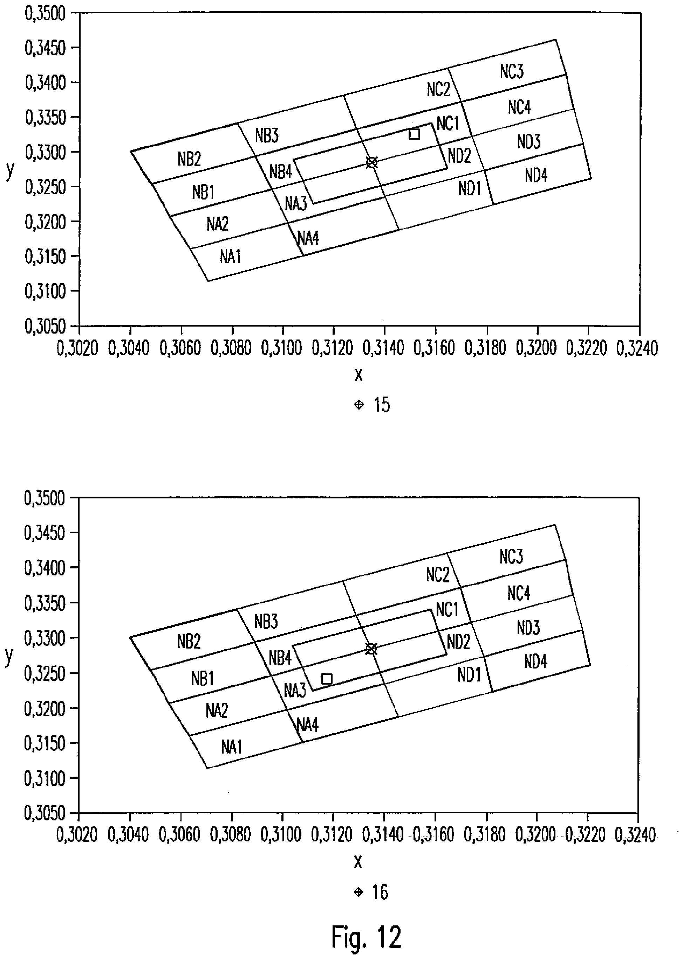

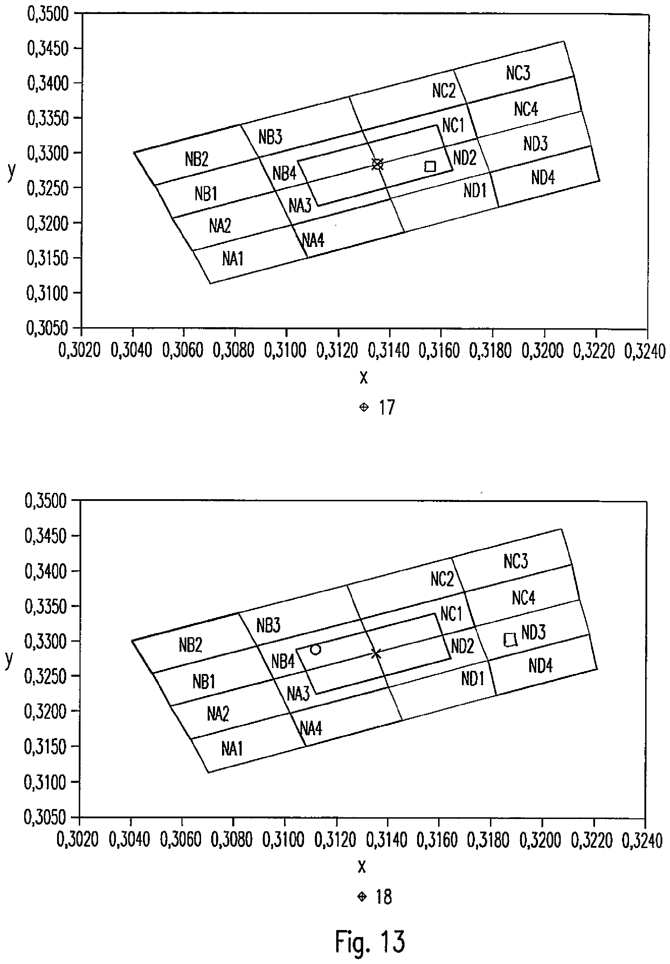

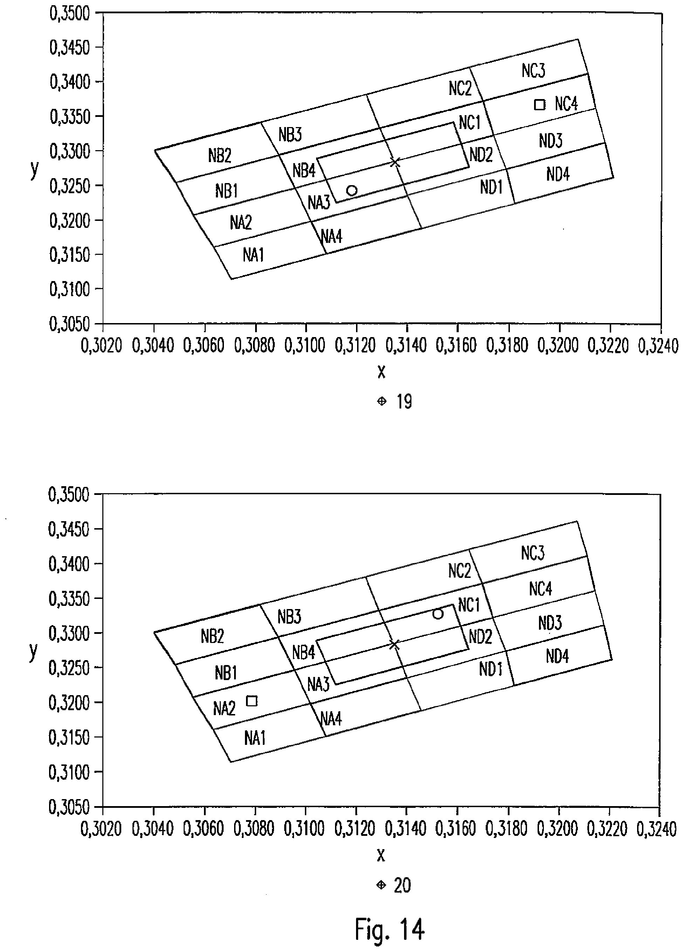

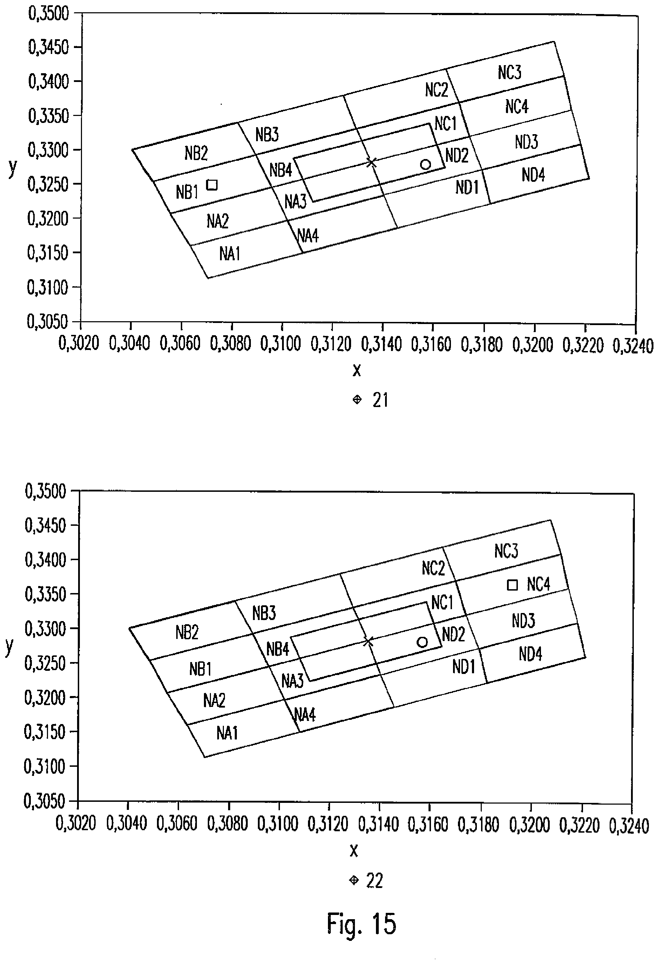

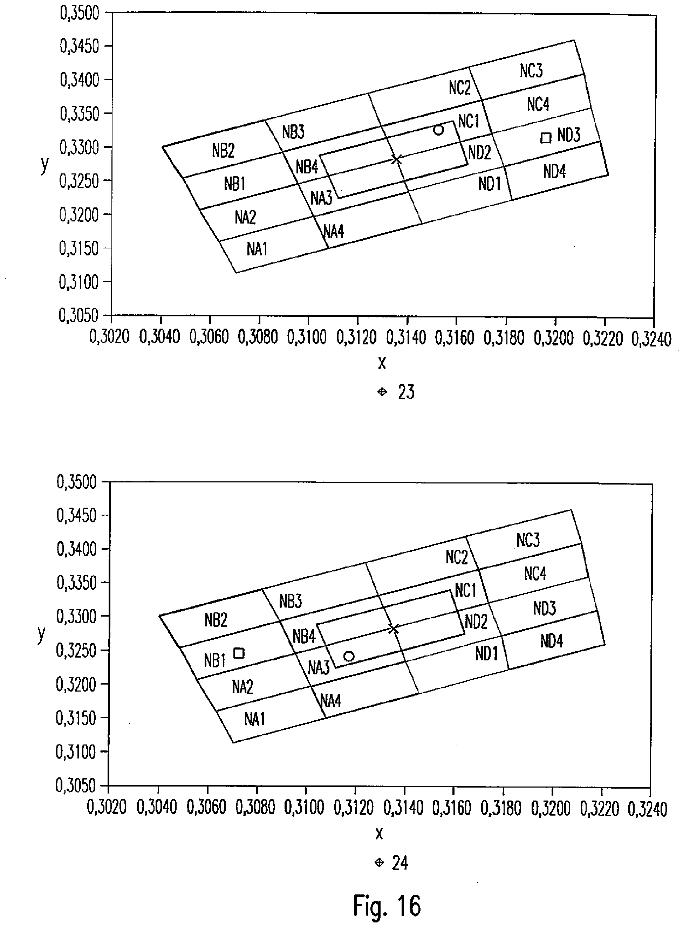

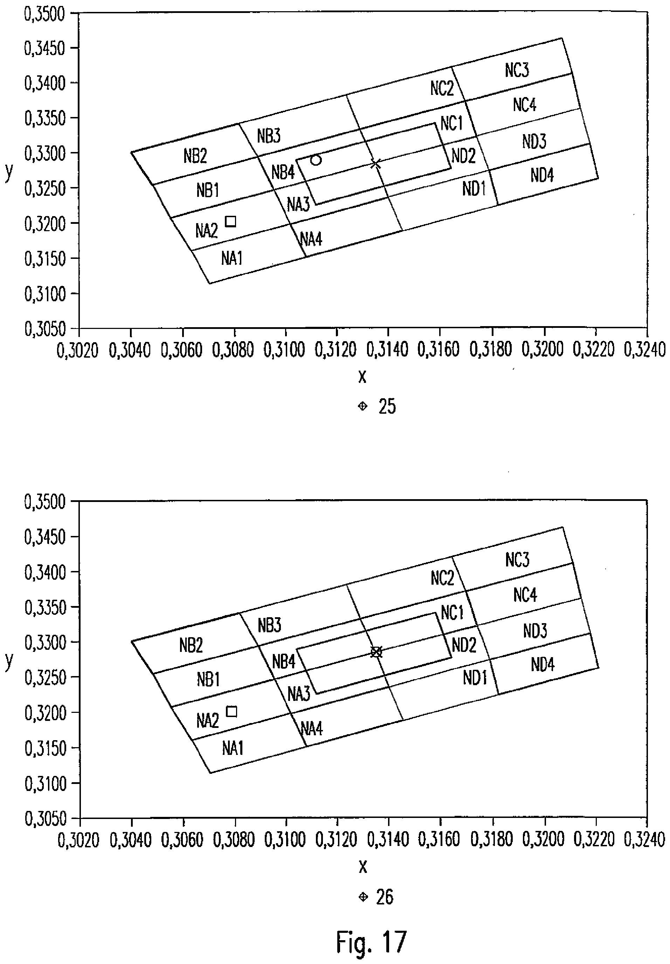

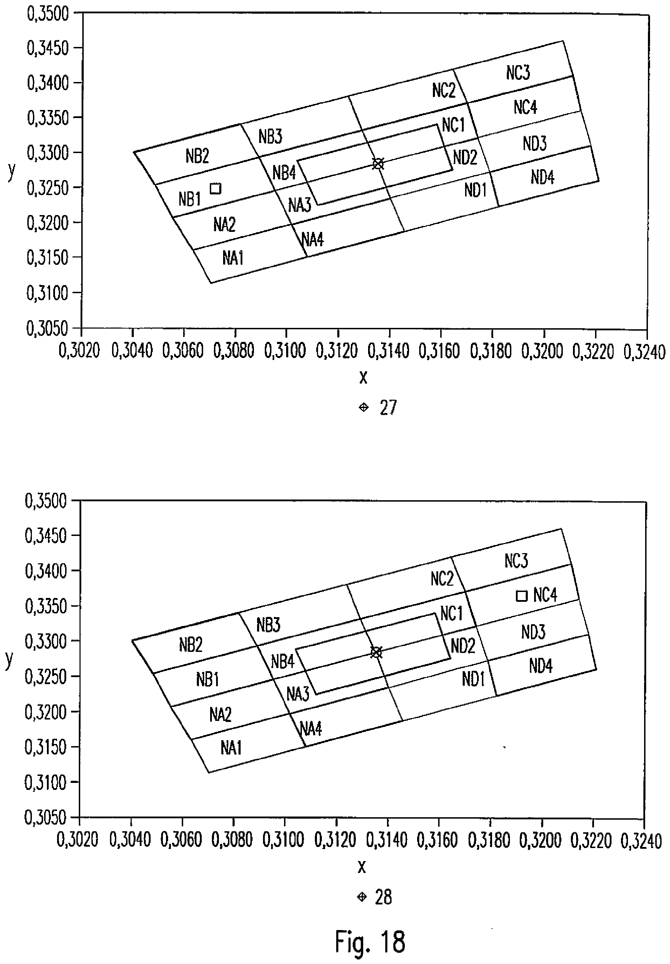

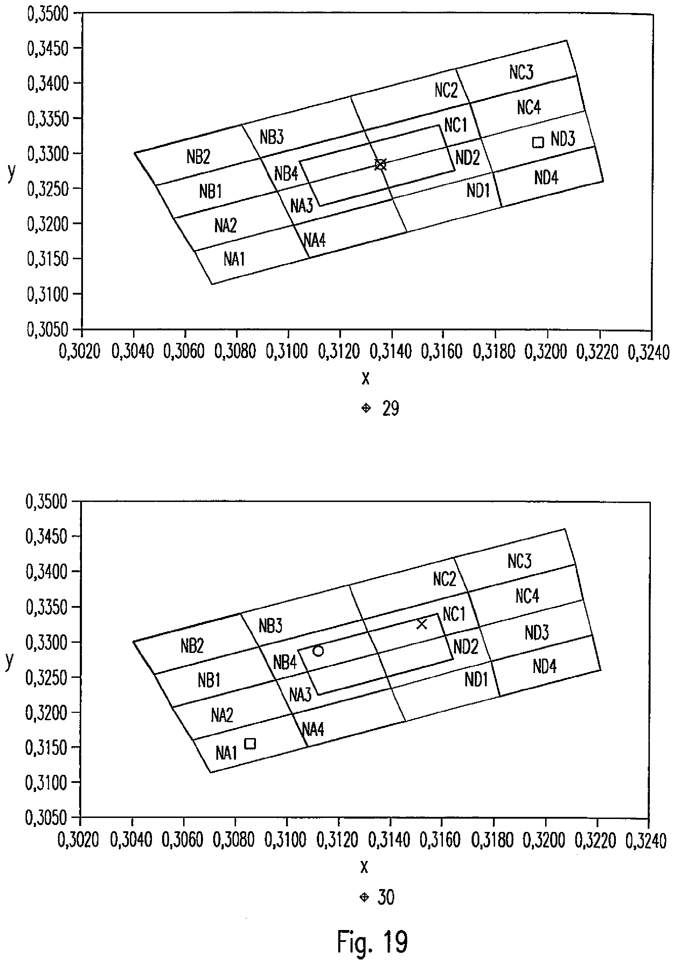

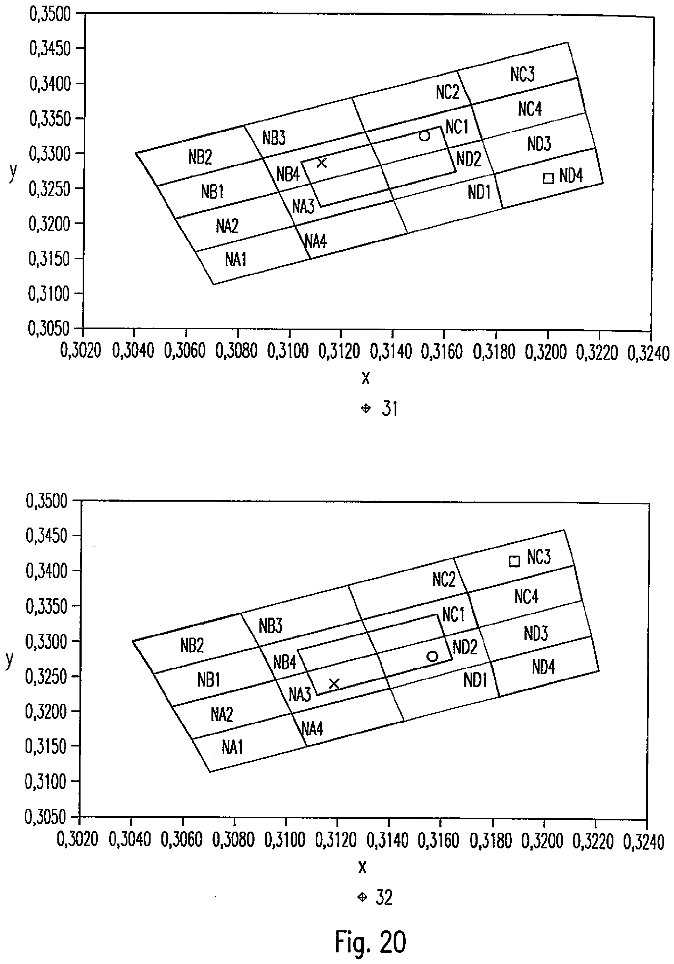

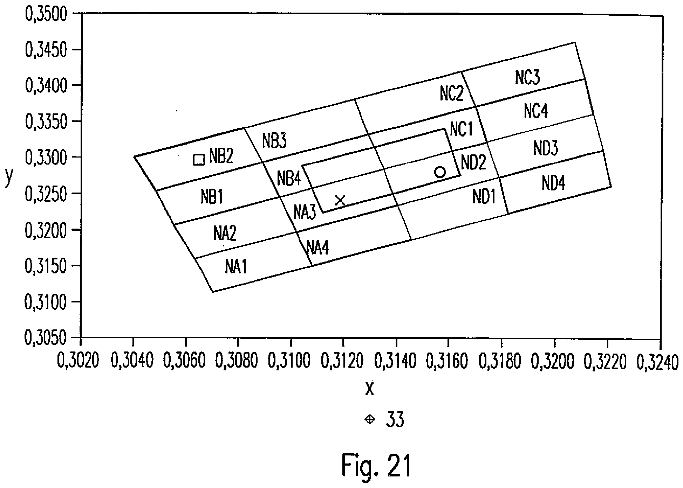

Jede Nummer 1 bis 33 unter dem entsprechenden Plan in Figur 5 bis 21 bezieht sich auf die Nummern 1 bis 33 in der Tabelle 1. Symbole x, □ und O korrelieren mit den gleichen Symbolen in Tabelle 1. Die x- und y-Werte entsprechen Werten in dem Chromatizitätsdiagramm, jedoch sind die spezifischen Werte nur beispielhaft gezeigt.

Detaillierte Beschreibung

Die zugrundliegende Aufgabe der vorliegenden Erfindung wird gemäß einer ersten Ausführungsform durch eine Beleuchtungsvorrichtung (1) zur Erzeugung von weißem Licht gelöst, die wenigsten einen Streifen aus drei Leuchtdioden (LEDs) (2) in einer linearen Anordnung aufweist. In der erfinderischen Beleuchtungsvorrichtung (1):

a) weist jeder LED-Streifen (2) vorzugsweise zwei äußere LEDs (3) und eine mittlere LED (4) auf;
b) sind vorzugsweise jede der äußeren LEDs (3) und die mittlere LED (4) phosphorkonvertierte weiße LEDs.

Außerdem ist der Abstand jeder der Farbkoordinaten der zwei äußeren LEDs zu der Farbkoordinate des Mischlichts der zwei äußeren LEDs und der mittleren LED kleiner als der Abstand der Farbkoordinate der mittleren LED zu den Farbkoordinaten des Mischlichts der zwei äußeren LEDs und der mittleren LED.

In dem Kontext der vorliegenden Erfindung weist die Beleuchtungsvorrichtung (1) wenigstens einen LED-Streifen (2) auf, wobei der LED-Streifen (2) vorzugsweise drei Leuchtdioden (LEDs) in einer linearen Anordnung aufweist oder daraus besteht. Jeder LED-Streifen (2) enthält somit typischerweise zwei äußere LEDs (3) und eine mittlere LED (4). Die LED-Streifen (2) sind typischerweise voneinander trennbar. Diese LED-Streifen (2) und oder die erfinderischen Beleuchtungsvorrichtung (1) können nach Bedarf (a) an (einer) Lichterkette(n), aber wahlweise auch an (einem) Bereich oder an (einer) räumlichen Anordnung(en) angeordnet werden.

Vorzugsweise emittiert die erfinderische Beleuchtungsvorrichtung (1) ein weißes Licht, wobei das weiße Licht typischerweise ein Mischlicht ist, das aus den weißen Lichtemissionen jeder der LEDs des wenigstens einen LED-Streifens (2) besteht. Vorzugsweise wird die weiße Farbe der Beleuchtungsvorrichtung (1) erhalten, indem das Licht der zwei äußeren LEDs (3) und der mittleren LED (4) jedes LED-Streifens (2) gemischt wird.

Noch besser ist das weiße (Misch-) Licht, das von der erfinderischen Beleuchtungsvorrichtung (1) emittiert wird, ein weißes Licht mit einer Farbtemperatur, die aus einer warmen weißen Farbe, einer kalten weißen Farbe oder einer Farbe zwischen einer warmen weißen Farbe und einer kalten weißen Farbe ausgewählt wird.

Vorzugsweise ist das weiße Licht, das von der Beleuchtungsvorrichtung (1) emittiert wird, ein weißes Mischlicht, besser mit einer Farbkoordinate, die sich auf oder nahe der Planckschen Kurve (Schwarzkörperkurve) befindet, eine weiße Farbkoordinate, die sich innerhalb einer MacAdam-Ellipse befindet, eine weiße Farbkoordinate, die sich auf oder nahe der ANSI-Bin-Kurve (ANSI C78.377-2008) oder in einem Bin oder vorzugsweise einem Sub-Bin davon befindet, oder eine weiße Farbkoordinate gemäß dem 1931 CIE- (Commission internationale de l'éclairage) Farbsystem.

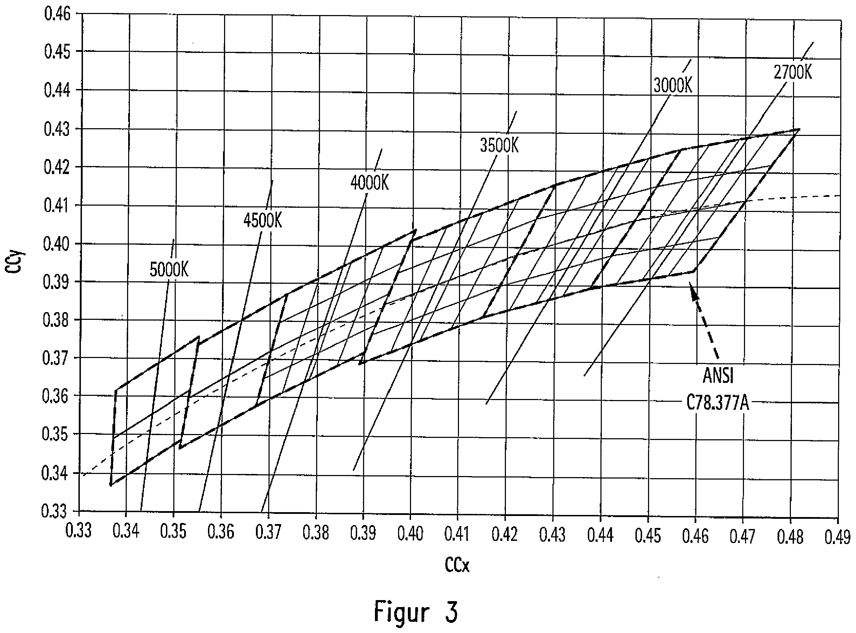

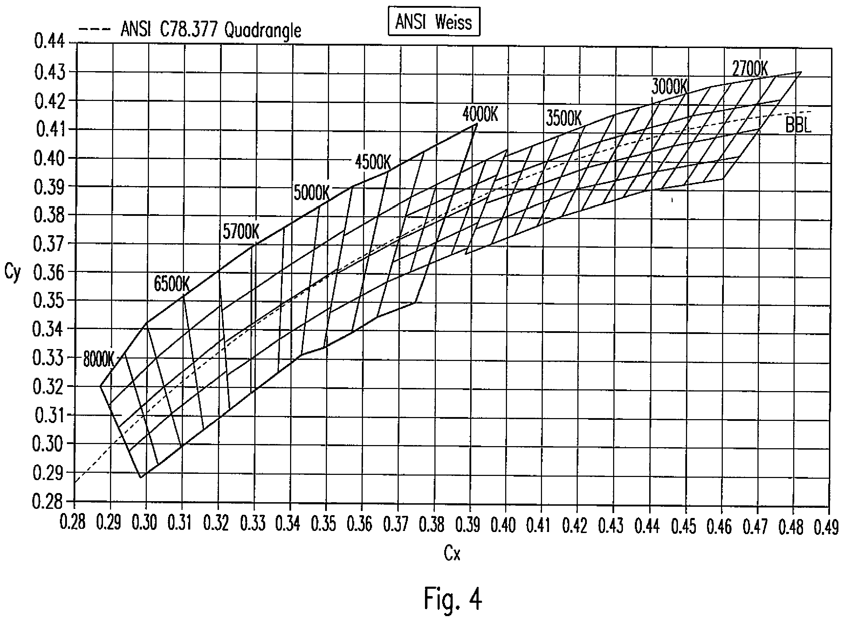

Im Allgemeinen können Farbkoordinaten in dem Kontext der vorliegenden Erfindung auf der Basis der ANSI-Bin-Kurve (ANSI C78.377-2008), einem Bin oder vorzugsweise einem Sub-Bin davon und/oder auf der Basis des 1931 CIE-(Commission internationale de l'éclairage) Farbsystems bestimmt werden. Bins und Sub-Bins, die gemäß der vorliegenden Erfindung geeignet sind, sind z.B. in Fig. 3 und 4 und in Tabelle 1 gezeigt, wobei sie vorzugsweise dem System der ANSI-Bin-Kurve (ANSI C78.377-2008) folgen.

In dem Kontext der vorliegenden Erfindung sind die Plancksche Kurve (Schwarzkörperkurve), die MacAdam-Ellipse, die ANSI-Bin-Kurve (ANSI C78.377-2008), ein Bin oder vorzugsweise ein Sub-Bin davon oder das 1931 CIE-(Commission internationale de l'éclairage) Farbsystem einem Fachmann wohlbekannt. Bins oder Sub-Bins derartiger Definitionen können weiter unterteilt oder erweitert werden, wie z.B. durch die weitere Definition von Bins oder Sub-Bins der ANSI-Bin-Kurve (ANSI C78.377-2008) definiert, wie sie von der Cree Incorporation, US ("Cree bins and subbins") entwickelt wurde. Derartige Bins und Sub-Bins, wie sie von der Cree Incorporation entwickelt wurden, sind auch in der Definition der Bins und Sub-Bins der vorliegenden Erfindung enthalten.

Gemäß einem Aspekt der vorliegenden Erfindung kann das weiße Licht, das von jeder der zwei äußeren LEDs (3) und von der mittleren LED (4) des LED-Streifens (2) der erfinderischen Beleuchtungsvorrichtung (1) emittiert wird, wiederum unabhängig voneinander eine Farbtemperatur zwischen warmem weißem Licht und kaltem weißem Licht, vorzugsweise eine Farbtemperatur, die aus warmem weißem Licht oder kaltem weißem Licht ausgewählt wird, und/oder eine Farbtemperatur zwischen warmem weißem Licht und kaltem weißem Licht, z.B. von neutralem weißem Licht haben.

In diesem Kontext kann vorzugsweise jede der einzelnen LEDs des LED-Streifens (2) der erfinderischen Beleuchtungsvorrichtung (1) unabhängig voneinander aus LEDs, die ein weißes Licht emittieren und eine Farbkoordinate, die sich auf oder nahe der Planckschen Kurve (Schwarzkörperkurve) befindet, eine weiße Farbkoordinate, die sich innerhalb einer MacAdam-Ellipse befindet, eine weiße Farbkoordinate, die sich auf oder nahe der ANSI-Bin-Kurve (ANSI C78.377-208) befindet oder in einem Bin oder vorzugsweise einem Sub-Bin davon befindet, und/oder eine weiße Farbkoordinate gemäß dem 1931 CIE (Commission internationale de l'éclairage) Farbsystem haben, ausgewählt werden.

Vorzugsweise wird das weiße Licht jeder der zwei äußeren LEDs (3) und der mittleren LED (4) des LED-Streifens (2) der erfinderischen Beleuchtungsvorrichtung (1) aus weißem Licht mit einer Farbtemperatur im Bereich von etwa 1500 K bis etwa 8000 K, besser einer Farbtemperatur in dem Bereich von etwa 2700 K bis etwa 6500 K, ausgewählt.

In dem Kontext der vorliegenden Erfindung liegt die Farbtemperatur von warmem weißem Licht vorzugsweise in dem Bereich von etwa 1500 K bis etwa 300 K, besser in dem Bereich von etwa 2700 K bis etwa 3000 K. Die Farbtemperatur von kaltem weißem Licht liegt vorzugsweise in dem Bereich von etwa 4000 K bis etwa 8000 K, besser in dem Bereich von etwa 4000 K bis etwa 6500 K. Die Farbtemperatur kann auch aus jedem mittleren Bereich zwischen kaltem und warmem weißem Licht ausgewählt werden, wie es durch einen der vorstehend erwähnten Werte oder aus einem Bereich, der typischerweise als "neutrales weißes Licht" bezeichnet wird, vorzugsweise im Bereich von etwa 3500 K bis etwa 4500 K gebildet wird.

Gemäß einem Aspekt wird die Farbkoordinate einer ersten äußeren LED (3) jedes LED-Streifens (2) der erfinderischen Beleuchtungsvorrichtung (1) aus einer weißen Farbkoordinate, wie vorstehend definiert, die sich in einem Bin oder vorzugsweise Sub-Bin der ANSI-Bin-Kurve (ANSI C78.377-2008) befindet, vorzugsweise einem Cree-Bin oder Sub-Bin davon, ausgewählt. Außerdem kann die Farbkoordinate der zweiten äußeren LED (3) des gleichen LED-Streifens (2) aus einer weißen Farbkoordinate, wie vorstehend definiert, die sich in einem Bin oder vorzugsweise Sub-Bin der ANSI-Bin-Kurve (ANSI 78.377-2008), wie vorstehend definiert, oder vorzugsweise einem Cree-Bin davon befindet, ausgewählt werden, wobei der Bin oder Sub-Bin entweder benachbart zu dem Bin oder Sub-Bin der Farbkoordinate der ersten äußeren LED (3) oder identisch zu dem Bin oder Sub-Bin der Farbkoordinate der ersten äußeren LED (3) ist. "Benachbart" kann in dem vorliegenden erfinderischen Kontext direkt benachbarte Sub-Bins (kein Sub-Bin dazwischen) oder Bins oder Sub-Bins umfassen, die durch einen oder mehrere Bins oder Sub-Bins voneinander getrennt sind.

In der erfinderischen Beleuchtungsvorrichtung (1) ist der Abstand jeder der Farbkoordinaten der zwei äußeren LEDs zu der Farbkoordinate des Mischlichts der zwei äußeren LEDs und der mittleren LED kleiner als der Abstand der Farbkoordinate der mittleren LED zu den Farbkoordinaten des Mischlichts der zwei äußeren LEDs und der mittleren LED. Die Farbkoordinate des Mischlichts der zwei äußeren LEDs und der mittleren LED kann auch als "Mitte" bezeichnet werden. Hier sind die Farbkoordinaten der zwei äußeren LEDs in größerer Nähe zueinander als die Farbkoordinate der ersten äußeren LED zu der Farbkoordinate der mittleren LED oder die Farbkoordinate der zweiten äußeren LED zu der Farbkoordinate der mittleren LED.

Für die Zwecke der vorliegenden Erfindung wird der Abstand jeder der Farbkoordinaten der LEDs jedes LED-Streifens (2) auf der Basis der Farbkoordinate des Mischlichts, das von allen drei weißes Licht emittierenden LEDs des LED-Streifens (2) erzeugt wird, berechnet. Das Mischlicht hat dabei eine Farbkoordinate, die als die "Mitte" einer dreieckigen Fläche definiert werden kann, die von den Farbkoordinaten der zwei äußeren LEDs (3) und der mittleren LED (4) definiert wird. Dies gilt insbesondere, wenn die Farbkoordinaten der zwei äußeren LEDs (3) zueinander verschieden sind. Die "Mitte" kann auf der Basis der Mittelwerte der x- und y-Koordinaten aller drei Farbkoordinaten berechnet werden.

Die Farbkoordinaten der zwei äußeren LEDs (3) können verschieden voneinander sein.

Die Bestimmung der Farbkoordinaten des Mischlichts der zwei äußeren LEDs und der mittleren LED ("Mitte") kann ausgeführt werden, indem die mittleren x- und y-Koordinaten jeder dieser LEDs wie folgt berechnet werden:

$$x_{Mitte} = (x_1 + x_2 + x_3)/3;$$

und

$$y_{Mitte} = (y_1 + y_2 + y_3)/3$$

Hier stellt $x_1 + x_2 + x_3$ vorzugsweise die Summe der X-Koordinaten der zwei äußeren ($x_1$, $x_3$) und der mittleren ($x_2$) LEDs dar, und $y_1 + y_2 + y_3$ stellt vorzugsweise die Summe der Y-Koordinaten der zwei äußeren ($y_1$, $y_3$) und der mittleren ($y_2$) LEDs dar. $x_{Mitte}$ und $y_{Mitte}$ stellen die mittleren x- und y-Koordinaten dar, deren Kombination die "Mitte", d.h. die Farbkoordinate des Mischlichts der zwei äußeren LEDs und der mittleren LED definiert.

In dem Fall, dass die Farbkoordinaten der zwei äußeren LEDs (3) nicht identisch zueinander sind, werden die Farbkoordinaten der zwei äußeren LEDs (3) vorzugsweise derart ausgewählt, dass der Abstand jeder der Farbkoordinaten der zwei äußeren LEDs (4) zu der Farbkoordinate des Mischlichts der zwei äußeren LEDs und der mittleren LED kleiner als der Abstand der Farbkoordinaten der mittleren LED zu den Farbkoordinaten des Mischlichts der zwei äußeren LEDs und der mittleren LED ist. Vorzugsweise werden Sub-Bins verwendet.

In diesem Fall, in dem die Farbkoordinaten der zwei äußeren LEDs (3) nicht identisch zueinander sind, werden die Farbkoordinaten jeder der zwei äußeren LEDs (3) der erfinderischen Beleuchtungsvorrichtung (1) vorzugsweise unabhängig voneinander aus einer weißen Farbkoordinate, wie vorstehend definiert, die sich in einem Bin oder Sub-bin der ANSI-Bin-Kurve (ANSI C78.377-2008), wie vorstehend definiert, vorzugsweise einem Cree-Bin oder Sub-Bin befindet, ausgewählt. Vorzugsweise werden Sub-Bins verwendet.

Falls außerdem die Farbkoordinaten der zwei äußeren LEDs (3) nicht identisch zueinander sind, wird der Bin oder der Sub-Bin der Farbkoordinate der ersten äußeren LED (3) vorzugsweise derart ausgewählt, dass er benachbart zu dem Bin oder Sub-Bin der Farbkoordinate der zweiten äußeren LED (3) ist oder in dem gleichen Sub-Bin ist. Die Auswahl des (benachbarten) Bin oder vorzugsweise Sub-Bin der Farbkoordinate der zweiten äußeren LED (3) wird vorzugsweise derart ausgeführt, dass ein Bin oder vorzugsweise Sub-Bin ausgewählt wird, der nahe oder sogar in nächster Nähe zu dem Bin oder vorzugsweise Sub-Bin der Farbkoordinate der ersten äußeren LED (3) ist. Vorzugsweise können die ausgewählten Bins oder Sub-Bins für die erste und für die zweite äußere LED (3) gemäß der ANSI-Bin-Kurve (ANSI C78.377-2008), wie vorstehend definiert, um nicht mehr als ein oder zwei Sub-Bins getrennt sein und am besten gemäß der ANSI-Bin-Kurve (ANSI C78.377-2008), wie vorstehend definiert, um nicht mehr als einen Sub-Bin getrennt sein oder können in dem gleichen Sub-Bin sein. Insbesondere bevorzugt sind die Farbkoordinaten bzw. die ausgewählten Bins oder Sub-Bins für die erste und die zweite äußere LED (3) direkt benachbart zueinander oder werden gemäß der ANSI-Bin-Kurve (ANSI C78.377-2008), wie vorstehend definiert, aus dem gleichen Sub-Bin ausgewählt. Vorzugsweise werden Sub-Bins verwendet.

Gemäß einem beispielhaften Aspekt des Falls, in dem die Farbkoordinaten der zwei äußeren LEDs (3) nicht identisch zueinander sind, kann ein Bin oder Sub-Bin oberhalb der Planckschen Kurve (Schwarzkörperkurve) angeordnet sein, der entsprechende oder direkt benachbarte Cross-Bin kann unterhalb der Planckschen Kurve (Schwarzkörperkurve) angeordnet sein. Vorzugsweise werden Sub-Bins verwendet.

Schließlich wird in dem Fall, in dem die Farbkoordinaten der zwei äußeren LEDs (3) nicht identisch zueinander sind, die Farbkoordinate der mittleren LED (4) aus einem Bin oder vorzugsweise Sub-Bin ausgewählt, der gemäß der ANSI-Bin-Kurve (ANSI C78.377-2008), wie vorstehend definiert, oder einem entsprechenden Cree-Cross-Bin oder Cross-Sub-Bin von dem Bin oder vorzugsweise Sub-Bin wenigstens einer der äußeren LEDs (3) um nicht mehr als 1 bis 4 Bins oder Sub-Bins, vorzugsweise um nicht mehr als 1 bis 3 Sub-Bins oder 2 bis 3 Sub-Bins, besser um nicht mehr als 1 oder 2 Sub-Bins und am besten um 1 oder 2 Bins oder vorzugsweise Sub-Bins getrennt ist, oder die Farbkoordinate der mittleren LED (4) kann in dem gleichen Sub-Bin wie wenigstens eine der äußeren LEDs (3) sein.

Gemäß einem beispielhaften Aspekt der vorliegenden Erfindung können aus Kombinationen von Bins oder Sub-Bins der ANSI-Bin-Kurve (ANSI C78.377-2008), wie im Folgenden definiert, geeignete Cross-Bins oder Cross-Sub-Bins ausgewählt werden.

Die Farbkoordinaten der zwei äußeren LEDs (3) und die Farbkoordinate der mittleren LED (4) können z.B. aus dem gleichen Bin oder Sub-Bin oder aus Kombinationen von Bins NA und NC oder NB und ND, wobei N in jedem der vorstehend definierten Fälle die Nummer des Bin, z.B. 0, 1, 2, 3, 4, 5, 6, 7, 8 oder 9 etc. in dem ANSI-Bin-Kurvensystem (ANSI C78.377-2008) darstellt, oder wie z.B. durch das Cree-Binsystem (Cree Inc., US) erweitert, ausgewählt werden. Cross-Bins können auch aus Kombinationen von Bins oder Sub-Bins NA und NB oder NC und ND oder aus Kombinationen von Bins ND und (N+1)B oder NC und (N+1)A, etc. ausgewählt werden, ohne darauf beschränkt zu sein.

Vorzugsweise können die Farbkoordinaten der zwei äußeren LEDs (3) und die Farbkoordinate der mittleren LED (4) z.B. aus Kombinationen von Sub-Bins NB4 und ND2, NC1 und NA3, aber auch aus Kombinationen von Sub-Bins NB1 und NA2, NB4 und NA3, NC1 und ND2, NC4 und ND3, NB1 und NB4, NB4 und NC1, NC1 und NC4, NA2 und NA3, NA3 und ND2, ND2 und ND3, NC4 und (N+1)B1, ND3 und (N+1)A2 etc. gemäß der ANSI-Bin-Kurve (ANSI C78.377-2008) ausgewählt werden, ohne darauf beschränkt zu sein. Wiederum stellt N die Nummer des Bin, z.B. 0, 1, 2, 3, 4, 5, 6, 7, 8 oder 9 etc. in dem ANSI-Bin-Kurvensystem dar.

In dem Fall, dass die Farbkoordinaten der zwei äußeren LEDs (3) nicht identisch zueinander sind, werden die Farbkoordinaten der zwei äußeren LEDs (3) unabhängig gemäß der ANSI-Bin-Kurve (ANSI C78.377-2008) entweder aus dem gleichen Bin oder Sub-Bin oder aus verschiedenen Bins oder Sub-Bins davon ausgewählt. In dem letzteren Fall findet die Auswahl von Kombinationen geeigneter Bins oder Sub-Bins gemäß der ANSI-Bin-Kurve (ANSI C78.377-2008) für die erste und für die zweite äußere LED (3) statt, wie vorstehend beschrieben.

Außerdem wird in dem Fall, dass die Farbkoordinaten der zwei äußeren LEDs (3) nicht identisch zueinander sind, die Farbkoordinate der mittleren LED (4) aus einem Bin oder vorzugsweise einem Sub-Bin ausgewählt, der von dem Bin oder vorzugsweise dem Sub-Bin wenigstens einer der äußeren LEDs (3), wie vorstehend definiert, um nicht mehr als 1 bis 4 Bins oder Sub-Bins, 2 bis 3 Bins oder Sub-Bins oder 1 oder 2 Bins oder Sub-Bins getrennt ist.

Gemäß einem besonders bevorzugten Aspekt werden geeignete Bins oder Sub-Bins aus den folgenden Kombinationen von Sub-Bins gemäß der ANSI-Bin-Kurve (ANSI C78.377-2008), vorzugsweise aus den Kombinationen 2 bis 33 ausgewählt:

Tabelle 1: Zeigt mögliche Kombinationen von Sub-Bins gemäß der ANSI-Bin-Kurve (ANSI C78.377-2008) gemäß der Erfindung, die vorzugsweise aus den Kombinationen 2 bis 33 ausgewählt werden. Die gezeigten Kombinationen 1 bis 33 entsprechen den Figuren 5 bis 21, wobei auf jede Nummer in der Tabelle 1 in der entsprechenden Figur von Figur 5 bis 21 Bezug genommen wird. Die Symbole X, □ und O korrelieren mit den Symbolen in Figur 5 bis 21. Der Ausdruck "NA3/NB3/NC1 oder ND2"bedeutet vorzugsweise "Mitte der Bins NA3/NB4/NC1 und ND2".

| Nr. | 1. äußere LED (3) X | Mittlere LED (4) □ | 2. äußere LED (3) ○ |
|---|---|---|---|
| 1 | NA3/NB4/NC1 oder ND2 | Gleich wie für 1. äußere LED | Gleich wie für 1. äußere LED |
| 2 | NB4 | NA3 | ND2 |
| 3 | NA3 | ND2 | NC1 |
| 4 | ND2 | NC1 | NB4 |
| 5 | NC1 | NB4 | NA3 |
| 6 | NC1 | NA1 | NC1 |
| 7 | NB4 | ND4 | NB4 |
| 8 | NA3 | NC3 | NA3 |
| 9 | ND2 | NB2 | ND2 |
| 10 | NC1 | ND1 | NB4 |
| 11 | NC1 | NA4 | NB4 |
| 12 | NA3 | NB3 | ND2 |
| 13 | NA3 | NC2 | ND2 |
| 14 | NA3/NB4/NC1 oder ND2 | NB4 | Gleich wie für 1. äußere LED |
| 15 | NA3/NB41NC1 oder ND2 | NC1 | Gleich wie für 1. äußere LED |
| 1.6 | NA3/NB4/NC1 oder ND2 | NA3 | Gleich wie für 1. äußere LED |
| 17 | NA3/NB4/NC1 oder ND2 | ND2 | Gleich wie für 1. äußere LED |
| 18 | NA3/NB4/NC1 oder ND2 | ND3 | NB4 |
| 19 | NA3/NB4/NC1 oder ND2 | NC4 | NA3 |
| 20 | NA3/NB4/NC1 oder ND2 | NA2 | NC1 |
| 21 | NA3/NB4/NC1 oder ND2 | NB1 | ND2 |
| 22 | NA3/NB4/NC1 oder ND2 | NC4 | ND2 |
| 23 | NA3/NB4/NC1 oder ND2 | ND3 | NC1 |
| 24 | NA3/NB4/NC1 oder ND2 | NB1 | NA3 |
| 25 | NA3/NB4/NC1 oder ND2 | NA2 | NB4 |
| 26 | NA3/NB4/NC1 or ND2 | NA2 | Gleich wie für 1. äußere LED |
| 27 | NA3/NB4/NC1 or ND2 | NB1 | Gleich wie für 1. äußere LED |
| 28 | NA3/NB4/NC1 or ND2 | NC4 | Gleich wie für 1. äußere LED |
| 29 | NA3/NB4/NC1 orND2 | ND3 | Gleich wie für 1. äußere LED |
| 30 | NC1 | NA1 | NB4 |
| 31 | NB4 | ND4 | NC1 |
| 32 | NA3 | NC3 | ND2 |
| 33 | NA3 | NB2 | ND2 |

In einem weiteren Aspekt der Beleuchtungsvorrichtung (1), wie hier definiert, wird das weiße Licht der Beleuchtungsvorrichtung (1) erhalten, indem das Licht der zwei äußeren LEDs (3) gemischt wird.

Vorzugsweise weist die erfinderische Beleuchtungsvorrichtung (1) einem Aspekt folgend mehrere Streifen aus drei phosphorkonvertierten weißen Leuchtdioden (LEDs) auf, wobei jeder LED-Streifen (2) aus zwei äußeren LEDs (3) und einer mittleren LED (4) besteht, wobei die Anzahl von LED-Streifen (2) vorzugsweise in einem Bereich zwischen 2 und 10000, z.B. zwischen 2 und 5000, 2 und 1000, am besten in einem Bereich zwischen 2 und 700, sogar noch besser in einem Bereich zwischen 2 und 500 liegt. Insbesondere bevorzugt sind die LED-Streifen (2) in einer linearen Form als eine LED-Kette oder in einer flächigen oder räumlichen Anordnung angeordnet.

In der Beleuchtungsvorrichtung (1) gemäß der vorliegenden Erfindung kann jeder LED-Streifen (2) eine Abdeckung aufweisen, die vorzugsweise eine Linse für jede der zwei äußeren LEDs (3) und die mittlere LED (4) umfasst. Eine derartige Abdeckung und/oder die Linse können aus jedem geeigneten Material, wie etwa. z.B. Polyethylen oder Polypropylen, Epoxidharz, wahlweise einer Silikonbeschichtung, etc. ausgebildet werden.

Ebenso weist jeder LED-Streifen (2) in der erfinderischen Beleuchtungsvorrichtung (1) vorzugsweise alternativ zu der vorstehenden Abdeckung eine Totalreflexions- (TIR-) Linse auf. Eine derartige Totalreflexions-(TIR-) Linse kann aus jedem geeigneten Material, wie etwa z.B. Polyethylen oder Polypropylen, Epoxid, einer Silikonbeschichtung etc., vorzugsweise wie vorstehend für die Abdeckung definiert, ausgebildet werden.

In der Beleuchtungsvorrichtung (1) gemäß der vorliegenden Erfindung können die LED-Streifen (2) vorzugsweise in Form einer Kette von LED-Streifen (2) bevorzugt über eine Reihenschaltung verbunden werden.

Die LEDs der erfinderischen Beleuchtungsvorrichtung (1), insbesondere der LEDs jedes LED-Streifens (2), wie hier definiert, werden typischerweise unabhängig voneinander aus beliebigen geeigneten LEDs ausgewählt. Vorzugsweise wird jede der zwei äußeren LEDs (3) und der mittleren LED (4) jedes LED-Streifens (2) unabhängig voneinander aus LEDs ausgewählt, die eine blaue LED und wenigstens einen Phosphor aufweisen, wobei der Phosphor vorzugsweise aus der Gruppe von Granaten, die mit Seltenen Erden dotiert sind, Thiogallaten, die mit Seltenen Erden dotiert sind, Aluminaten, die mit Seltenen Erden dotiert sind, Orthosilikaten, die mit Seltenen Erden dotiert sind und/oder Oxyorthosilikaten, die mit Seltenen Erden dotiert sind, ausgewählt wird.

Derartige Phosphore werden vorzugsweise in einem transparenten Epoxidgussharz verteilt. Die Phosphore weisen vorzugsweise lumineszierende Pigmente auf oder bestehen daraus und haben vorzugsweise Partikelgrößen von typischerweise $\leq 25\ \mu m$, besser $\leq 20\ \mu m$, am besten $\leq 20\ \mu m$, z.B. zwischen 2 - 25 $\mu m$, 2 - 20 $\mu m$, 2 - 15 $\mu m$, 1 - 10 $\mu m$ oder sogar 1 - 4 $\mu m$. Die Phosphore haben vorzugsweise ein $d_{50} \leq 5\ \mu m$, vorzugsweise $\leq 4\ \mu m$, noch besser $\leq 3\ \mu m$, z.B. zwischen 1-5 $\mu m$, 2 - 5 $\mu m$, 1 - 4 $\mu m$ oder sogar 1 - 3 $\mu m$.

Beispielhaft erwähnte Phosphore, die für die vorliegende Erfindung geeignet sind, umfassen, ohne darauf beschränkt zu sein, Granate, die mit Seltenen Erden dotiert sind, wie etwa YAG:Ce ($Y_3Al_5O_{12}:Ce^{3+}$), oder andere Granate, die mit Seltenen Erden dotiert sind, wie etwa $Y_3Ga_5O_{12}:Ce^{3+}$), $Y(Al, Ga)_{50}O_{12}:Ce^{3+}$ und $Y(Al, Ga)_5O_{12}:Tb^{3+}$), etc. Weitere Phosphore, die für die vorliegende Erfindung geeignet sind, können ausgewählt werden aus: Thiogallaten, die mit Seltenen Erden dotiert sind, die z.B. $CaGa_2S_4:Ce^{3+}$, $SrGa_2S_5:Ce^{3+}$ umfassen, ohne darauf beschränkt zu sein; oder aus Aluminaten, die mit Seltenen Erden dotiert sind, die z.B. $YAlO_3:Ce^{3+}$, $YGaO_3:Ce^{3+}$, $Y(Al, Ga)O_3:Ce^{3+}$ umfassen, ohne darauf beschränkt zu sein; aus Orthosilikaten, die mit Seltenen Erden dotiert sind, die z.B. Erdalkaliorthosilikat, das mit zweiwertigem Europium aktiviert ist, mit der Formel a) $(2-x-y)SrO \cdot x(Ba_u, Ca_v)O \cdot (1-a-b-c-d)SiO_2 \cdot aP_2O_2\ bAl_2O_3\ cB_2O_3\ dGeO_2:yEu^{2+}$, wobei $0 \leq x < 1{,}6$, $0{,}005 < y < 0{,}5$, $x+y < 1{,}6$, $0 \leq a$, b, c, $d < 0{,}5$ und u+v =1 oder mit der Formel b) $(2-x-y)BaO \cdot x(Sr_u, Ca_v)O \cdot (1-a-b-cd)SiO_2 \cdot aP_2O_5\ bAl_2O_3\ cB_2O_3\ dGeO_2:yEu^{2+}$, wobei $0{,}01 \leq x < 1{,}6$, $0{,}005 < y < 0{,}5$, $0 \leq a$, b, c, $d < 0{,}5$, u+v =1 und $u \cdot v \geq 0{,}4$ oder eine Mischung der Formel a) und b) umfassen, ohne darauf beschränkt zu sein; aus Oxyorthosilikaten, die mit Seltenen Erden dotiert sind, wie etwa $M_2SiO_5:Ce^{3+}$ (M:Sc,Y, Sc), z.B. $Y_2SiO_5:Ce^{3+}$, umfassen, ohne darauf beschränkt zu sein, wobei das Yttrium in den Yttriumverbindungen auch durch Scandium oder Lanthan ersetzt werden kann; oder aus Phosphoren mit der folgenden Formel $A_3B_5X_{12}:M$, wobei die Variablen als A = Y, Ca, Sr; B = Al, Ga, Si; X = O, S und M = $Ce^{3+}$, $Tb^{3+}$ definiert sind.

Eine blaue LED in dem Kontext von LEDs jedes LED-Streifens (2) der erfinderischen Beleuchtungsvorrichtung (1) basiert vorzugsweise auf einem strahlungsemittierenden Halbleiterkörper, insbesondere mit einer aktiven Halbleiterschicht oder Halbleiterschichtfolge von $Ga_xIn_{1-x}N$ oder $Ga_xAl_{1-x}N$ oder besteht daraus, welche im Betrieb eine elektromagentische Strahlung in dem blauen Spektralbereich emittiert. In Kombination mit wenigstens einem Phosphor, wie hier beschrieben, vorzugsweise mit wenigstens einem der vorstehend bestimmten Phosphore, erzeugen die blauen LEDs, die die Basis jeder LED jedes LED-Streifens (2), wie hier definiert, bilden, ein phosphorkonvertiertes weißes Licht.

Die Phosphore, wie vorstehend definiert, werden vorzugsweise in einer Gusszusammensetzung verteilt, welche die aktive Halbleiterschicht normalerweise, wie vorstehend beschrieben, bedeckt, wodurch die phosphorkonvertierte weiße LED, wie sie gemäß der vorliegenden Erfindung verwendet wird, gebildet wird.

Gemäß einem weiteren Aspekt kann die erfinderische Beleuchtungsvorrichtung (1) ferner eine Steuerschaltung auf der Hauptplatine und/oder eine Leistungsversorgungseinheit und/oder eine Justiervorrichtung, vorzugsweise für jeden LED-Streifen (2), aufweisen. In diesem Kontext können die Steuerschaltung auf der Hauptplatine und/oder die Leistungsversorgung die an jede LED jedes LED-Streifens (2) gelieferte Spannung unabhängig ansprechen und modulieren, so dass die Farbtemperatur, die Farbkoordinate und/oder die Lichtausgabe jedes LED-Streifens (2), falls gewünscht, getrennt eingestellt werden können.

Erfinderische Beleuchtungsvorrichtungen (1), wie vorstehend beschrieben, können z.B. in jedem Produkt oder allgemein einer Lampen- oder Beleuchtungsvorrichtung, z.B. mit einer länglichen oder flächigen Form, wie etwa Lichterketten, Beleuchtungsvorrichtungen im Allgemeinen, erleuchteten Werbevorrichtungen, Reklameflächen, einer Beleuchtungsvorrichtung (1) für private oder industrielle Zwecke, z.B. Tageslichter oder Rücklichter von Autos, etc. oder jede andere geeignete Beleuchtungsvorrichtung verwendet werden. Vorzugsweise sind die LED-Streifen (2) der erfinderischen Beleuchtungsvorrichtungen (1) derart ausgebildet, dass sie eine Reihenschaltung zulassen, indem z.B. eine Seite des LED-Streifens (2) mit einem aufzunehmenden Verbinder und auf der entgegengesetzten Seite des LED-Streifens (2) mit einem aufnehmenden Verbinder versehen ist.

Die Beleuchtungsvorrichtung der vorliegenden Erfindung kann durch ein Verfahren zur Herstellung einer weißes Licht emittierenden LED-Vorrichtung hergestellt werden, wobei das Verfahren vorzugsweise die folgenden Schritte aufweist:

a) Auswählen von zwei äußeren LEDs (3) und einer mittleren LED (4) unabhängig voneinander aus phosphorkonvertierten weißen LEDs, vorzugsweise wie hier definiert;
wobei der Abstand jeder der Farbkoordinaten der zwei äußeren LEDs zu der Farbkoordinate des Mischlichts der zwei äußeren LEDs und der mittleren LED kleiner als der Abstand der Farbkoordinate der mittleren LED zu den Farbkoordinaten des Mischlichts der zwei äußeren LEDs und der mittleren LED ist; und

b) Ausbilden wenigstens eines LED-Streifens (2) aus den zwei äußeren LEDs (3) und der mittleren LED (4), wobei die LEDs in einer linearen Anordnung, vorzugsweise derart sind, dass jeder LED-Streifen (2) zwei äußere LEDs (3) und eine mittlere LED (4) aufweist oder daraus besteht.

In dem Verfahren sind der LED-Streifen (2) und die weißes Licht emittierende LED-Vorrichtung vorzugsweise wie für die erfinderische Beleuchtungsvorrichtung (1) vorstehend definiert. Jeder der für die erfinderische Beleuchtungsvorrichtung (1) diskutierten Aspekte kann in dem Verfahren verwendet und angewendet werden.

Die erfinderische Beleuchtungsvorrichtung (1), wie hier definiert, kann durch das Verfahren, wie vorstehend offenbart, zur Herstellung einer weißes Licht emittierenden LED-Vorrichtung erhalten werden oder erhaltbar sein. Noch besser ist die Beleuchtungsvorrichtung gemäß einem insbesondere bevorzugten Aspekt durch ein Verfahren, wie vorstehend definiert, erhaltbar, wobei der Schritt b) des Ausbildens wenigstens eines LED-Streifens (2) aus den zwei äußeren LEDs (3) und der mittleren LED (4) eine Beleuchtungsvorrichtung (1), wie ursprünglich gemäß der vorliegenden Erfindungsoffenbarung definiert, ausbildet.

Gemäß einem anderen Aspekt wird die zugrunde liegende Aufgabe durch die Verwendung wenigstens eines Streifens, der aus drei Leuchtdioden (LEDs) in einer linearen Anordnung zur Erzeugung von weißem Licht besteht, gelöst, wobei

a) jeder LED-Streifen (2) zwei äußere LEDs (3) und eine mittlere LED (4) aufweist;
b) jede der äußeren LEDs (3) und die mittlere LED (4) phosphorkonvertierte weiße LEDs sind; und
c) der Abstand jeder der Farbkoordinaten der zwei äußeren LEDs zu der Farbkoordinate des Mischlichts der zwei äußeren LEDs und der mittleren LED kleiner als der Abstand der Farbkoordinate der mittleren LED zu den Farbkoordinaten des Mischlichts der zwei äußeren LEDs und der mittleren LED ist.

In der Verwendung ist der wenigstens eine Streifen, der aus drei Leuchtdioden (LEDs) besteht (LED-Streifen (2)), wie vorstehend für die erfinderische Beleuchtungsvorrichtung (1) definiert. Jeder der für die erfinderische Beleuchtungsvorrichtung (1) diskutierten Aspekte kann ähnlich auf die erfinderische Verwendung angewendet werden.

Wenn nicht anders angegeben, haben alle technischen wissenschaftlichen Begriffe, Begriffe der Technik und Akronyme, wie sie hier verwendet werden, die Bedeutung, die von jemandem mit gewöhnlichen Kenntnissen der Technik auf dem Gebiet allgemein verstanden wird.

Nachdem die vorliegende Erfindung und ihre Vorteile somit beschrieben wurden, sollte zu schätzen gewusst werden, dass die verschiedenen Aspekte und Ausführungsformen der vorliegenden Erfindung, wie hier offenbart, lediglich veranschaulichend für spezifische Weisen sind, um die Erfindung herzustellen und zu verwenden, wenn die beigefügten Patentansprüche und die vorangehende detaillierte Beschreibung berücksichtigt werden.

**Patentansprüche**

1. Beleuchtungsvorrichtung (1) zur Erzeugung von weißem Licht, die wenigstens einen Streifen aus drei Leuchtdioden (2) in einer linearen Anordnung aufweist, wobei:

- a) jeder Streifen aus drei Leuchtdioden (2) zwei äußere Leuchtdioden (3) und eine mittlere Leuchtdiode (4) aufweist;
- b) jede der zwei äußeren Leuchtdioden (3) und die mittlere Leuchtdiode (4) phosphorkonvertierte weiße Leuchtdioden sind; und
- c) der Abstand jeder der Farbkoordinaten der zwei äußeren Leuchtdioden zu der Farbkoordinate des Mischlichts der zwei äußeren Leuchtdioden und der mittleren Leuchtdiode kleiner als der Abstand der Farbkoordinate der mittleren Leuchtdiode zu der Farbkoordinate des Mischlichts der zwei äußeren Leuchtdioden und der mittleren Leuchtdiode ist,

**dadurch gekennzeichnet, dass**

- die Farbkoordinaten der zwei äußeren Leuchtdioden (3) nicht identisch zueinander sind, wobei die Farbkoordinaten für die erste und für die zweite äußere Leuchtdiode gemäß der ANSI-BIN-Kurve, ANSI C78.377-2008, um nicht mehr als 1 oder 2 Sub-Bins getrennt oder in dem gleichen Sub-Bin sind, und die Farbkoordinate der mittleren Leuchtdiode (4) aus einem Bin oder Sub-Bin ausgewählt wird, der gemäß der ANSI-BIN-Kurve, ANSI C78.377-2008, um 2 bis 4 Bins oder Sub-Bins von einem Bin oder Sub-Bin wenigstens einer der äußeren Leuchtdioden (3) getrennt ist,

wobei das weiße Licht jeder der zwei äußeren Leuchtdioden (3) und der mittleren Leuchtdiode (4) eine Farbtemperatur hat, die unabhängig voneinander aus einer Farbtemperatur zwischen warmen weißem Licht und kaltem weißem Licht im Bereich zwischen etwa 2700 K bis etwa 6500 K ausgewählt wird.

2. Beleuchtungsvorrichtung (1) nach Anspruch 1, wobei die weiße Farbe der Beleuchtungsvorrichtung (1) durch Mischen des Lichts der zwei äußeren Leuchtdioden (3) und der mittleren Leuchtdiode (4) jedes Streifens aus drei Leuchtdioden (2) erhalten wird.

3. Beleuchtungsvorrichtung (1) nach einem der Ansprüche 1 bis 2, wobei die Beleuchtungsvorrichtung (1) mehrere Streifen aus drei Leuchtdioden (2) aufweist, wobei jeder Streifen aus drei Leuchtdioden (2) aus zwei äußeren Leuchtdioden (3) und einer mittleren Leuchtdiode (4) besteht, wobei die Anzahl von Streifen aus drei Leuchtdioden (2) in einem Bereich zwischen etwa 2 und 10000 , zwischen etwa 2 und 5000 oder zwischen etwa 2 und 1000 liegt.

4. Beleuchtungsvorrichtung (1) nach einem der Ansprüche 1 bis 3, wobei die Streifen aus drei Leuchtdioden (2) in einer linearen Form als eine LeuchtdiodenKette oder in einer flächigen oder räumlichen Anordnung angeordnet sind.

5. Beleuchtungsvorrichtung (1) nach einem der Ansprüche 1 bis 4, wobei jeder Streifen aus drei Leuchtdioden (2) auf einer Seite einen aufzunehmenden Verbinder und auf der entgegengesetzten Seite des Streifens aus drei Leuchtdioden (2) einen aufnehmenden Verbinder aufweist.

6. Beleuchtungsvorrichtung (1) nach einem der Ansprüche 1 bis 5, wobei jeder Streifen aus drei Leuchtdioden (2) eine Abdeckung (5) aufweist, die eine Linse für jede der zwei äußeren Leuchtdioden (3) und die mittlere Leuchtdiode (4) umfasst.

7. Beleuchtungsvorrichtung (1) nach einem der Ansprüche 1 bis 6, wobei jeder Streifen aus drei Leuchtdioden (2) eine totalreflektierende Linse aufweist.

8. Beleuchtungsvorrichtung (1) nach einem der Ansprüche 1 bis 7, wobei die Streifen aus drei Leuchtdioden (2) in Form einer Kette aus Streifen aus drei Leuchtdioden (2) über eine Reihenschaltung verbunden sind.

9. Beleuchtungsvorrichtung (1) nach einem der Ansprüche 1 bis 8, wobei die zwei äußeren Leuchtdioden (3) und die mittlere Leuchtdiode (4) unabhängig voneinander aus Leuchtdioden ausgewählt sind, die eine blaue LED und wenigstens einen Phosphor aufweisen.

10. Beleuchtungsvorrichtung (1) nach Anspruch 9 , wobei der Phosphor aus der Gruppe ausgewählt wird, die Granate, die mit Seltenen Erden dotiert sind, einschließlich YAG, Thiogallate, die mit Seltenen Erden dotiert sind, Aluminate, die mit Seltenen Erden dotiert sind, Orthosilikate, die mit Seltenen Erden dotiert sind und/oder Oxyorthosilikate, die mit Seltenen Erden dotiert sind, aufweist oder aus diesen besteht.

11. Beleuchtungsvorrichtung (1) nach einem der Ansprüche 1 bis 10, wobei die Beleuchtungsvorrichtung (1) ferner eine Steuerschaltung auf einer Hauptplatine und/oder eine Leistungsversorgungseinheit und/oder eine Justiervorrichtung aufweist.

**12.** Beleuchtungsvorrichtung nach Anspruch 11, wobei die die Beleuchtungsvorrichtung (1) eine Steuerschaltung auf einer Hauptplatine und/ oder eine Leistungsversorgungseinheit und/oder eine Justiervorrichtung für jeden Streifen aus drei Leuchtdioden (2) aufweist.

**13.** Beleuchtungsvorrichtung (1) nach einem der Ansprüche 1 bis 12, wobei die Beleuchtungsvorrichtung eine Lichterkette, eine beleuchtete Werbevorrichtung, eine Reklamefläche, ein Tagfahrlicht für Autos oder ein Rücklicht für Autos ist.

**Claims**

**1.** Lighting device (1) for generating white light, which comprises at least one strip of three light-emitting diodes (2) in a linear arrangement, wherein:

   • a) each strip of three light-emitting diodes (2) comprises two outer light-emitting diodes (3) and a middle light-emitting diode (4);
   • b) each of the two outer light-emitting diodes (3) and the middle light-emitting diode (4) are phosphor-converted white light-emitting diodes; and
   • c) the distance of each of the color coordinates of the two outer light-emitting diodes to the color coordinate of the mixed light of the two outer light-emitting diodes and the middle light-emitting diode is smaller than the distance of the color coordinate of the middle light-emitting diode to the color coordinate of the mixed light of the two outer light-emitting diodes and the middle light-emitting diode,
   **characterized in that**
   • the color coordinates of the two outer light-emitting diodes (3) are not identical to one another, wherein the color coordinates for the first and for the second outer light-emitting diode are separated by no more than 1 or 2 sub-bins or are in the same sub-bin in accordance with the ANSI BIN curve, ANSI C78.377-2008, and the color coordinate of the middle light-emitting diode (4) is selected from a bin or sub-bin which, according to the ANSI-BIN curve, ANSI C78.377-2008, is separated from a bin or sub-bin of at least one of the outer light-emitting diodes (3) by 2 to 4 bins or sub-bins,
   wherein the white light of each of the two outer light-emitting diodes (3) and the middle light-emitting diode (4) has a color temperature which is independently selected from a color temperature between warm white light and cold white light in the range between approximately 2,700 K to approximately 6,500 K.

**2.** Lighting device (1) according to Claim 1, wherein the white color of the lighting device (1) is obtained by mixing the light of the two outer light-emitting diodes (3) and the middle light-emitting diode (4) of each strip of three light-emitting diodes (2) .

**3.** Lighting device (1) according to any of Claims 1 to 2, wherein the lighting device (1) comprises a plurality of strips of three light-emitting diodes (2), wherein each strip of three light-emitting diodes (2) consists of two outer light-emitting diodes (3) and a middle light-emitting diode (4), wherein the number of strips of three light-emitting diodes (2) is in a range between approximately 2 and 10,000, between approximately 2 and 5,000 or between approximately 2 and 1,000.

**4.** Lighting device (1) according to any of Claims 1 to 3, wherein the strips of three light-emitting diodes (2) are arranged in a linear form as a light-emitting diode chain or in a flat or spatial arrangement.

**5.** Lighting device (1) according to any of Claims 1 to 4, wherein each strip of three light-emitting diodes (2) comprises a male connector on one side and a female connector on the opposite side of the strip of three light-emitting diodes (2).

**6.** Lighting device (1) according to any of Claims 1 to 5, wherein each strip of three light-emitting diodes (2) comprises a cover (5) which includes a lens for each of the two outer light-emitting diodes (3) and the middle light-emitting diode (4).

**7.** Lighting device (1) according to any of Claims 1 to 6, wherein each strip of three light-emitting diodes (2) comprises a totally reflecting lens.

**8.** Lighting device (1) according to any of Claims 1 to 7, wherein the strips of three light-emitting diodes (2) are connected in the form of a chain of strips of three light-emitting diodes (2) via a series connection.

9. Lighting device (1) according to any of Claims 1 to 8, wherein the two outer light-emitting diodes (3) and the middle light-emitting diode (4) are selected independently of one another from light-emitting diodes, which have a blue LED and at least one phosphor.

10. Lighting device (1) according to Claim 9, wherein the phosphor is selected from the group comprising or consisting of garnets doped with rare earths, including YAG, thiogallates doped with rare earths, aluminates doped with rare earths, orthosilicates doped with rare earths and/or oxyorthosilicates doped with rare earths.

11. Lighting device (1) according to any of Claims 1 to 10, wherein the lighting device (1) further comprises a control circuit on a main circuit board and/or a power supply unit and/or an adjusting device.

12. Lighting device according to Claim 11, wherein the lighting device (1) comprises a control circuit on a main circuit board and/or a power supply unit and/or an adjusting device for each strip of three light-emitting diodes (2).

13. Lighting device (1) according to any of Claims 1 to 12, wherein the lighting device is a chain of lights, an illuminated advertising device, an advertising surface, a daytime running light for cars or a taillight for cars.

## Revendications

1. Dispositif d'éclairage (1) servant à produire de la lumière blanche et présentant au moins une bande de trois diodes électroluminescentes (2) en disposition linéaire, et dans lequel :

   • a) chaque bande de trois diodes électroluminescentes (2) présente deux diodes électroluminescentes extérieures (3) et une diode électroluminescente centrale (4) ;
   • b) chacune des deux diodes électroluminescentes extérieures (3) et la diode électroluminescente centrale (4) sont des diodes électroluminescentes blanches à conversion par luminophore ; et
   • c) l'écart de chacune des coordonnées de couleur des deux diodes électroluminescentes extérieures par rapport à la coordonnée de couleur de la lumière mélangée des deux diodes électroluminescentes extérieures et de la diode électroluminescente centrale est inférieur à l'écart de la coordonnée de couleur de la diode électroluminescente centrale par rapport à la coordonnée de couleur de la lumière mélangée des deux diodes électroluminescentes extérieures et de la diode électroluminescente centrale,
   **caractérisé en ce que**
   • les coordonnées de couleur des deux diodes électroluminescentes extérieures (3) ne sont pas identiques l'une à l'autre, les coordonnées de couleur de la première et de la deuxième diode électroluminescente extérieure, selon la courbe à bins ANSI, (ANSI C78.377 2008), n'étant pas séparées de plus d'1 ou 2 sous-bins ou étant dans le même sous-bin, et la coordonnée de couleur de la LED centrale (4) est sélectionnée dans un bin ou sous-bin qui, selon la courbe à bins ANSI (ANSI C78.377 2008), est séparé de 2 à 4 bins ou sous-bins d'un bin ou sous-bin d'au moins une des diodes électroluminescentes extérieures (3),
   ladite lumière blanche de chacune des deux diodes électroluminescentes extérieures (3) et de la diode électroluminescente centrale (4) a une température de couleur correspondant individuellement à une température de couleur comprise entre la lumière blanche chaude et la lumière blanche froide dans la plage allant d'environ 2700 K à environ 6500 K.

2. Dispositif d'éclairage (1) selon la revendication 1, dans lequel la couleur blanche du dispositif d'éclairage (1) est obtenue par mélange de la lumière des deux diodes électroluminescentes extérieures (3) et de la diode électroluminescente centrale (4) de chaque bande de trois diodes électroluminescentes (2).

3. Dispositif d'éclairage (1) selon l'une des revendications 1 et 2, dans lequel le dispositif d'éclairage (1) présente une pluralité de bandes de trois diodes électroluminescentes (2), chaque bande de trois diodes électroluminescentes (2) consistant en deux diodes électroluminescentes extérieures (3) et une diode électroluminescente centrale (4), le nombre de bandes de trois diodes électroluminescentes (2) étant compris entre environ 2 et 10000, entre environ 2 et 5000 ou entre environ 2 et 1000.

4. Dispositif d'éclairage (1) selon l'une des revendications 1 à 3, dans lequel les bandes de trois diodes électroluminescentes (2) sont disposées de manière linéaire sous forme de chaîne de diodes électroluminescentes ou selon une disposition plate ou spatiale.

5. Dispositif d'éclairage (1) selon l'une quelconque des revendications 1 à 4, dans lequel chaque bande de trois diodes électroluminescentes (2) présente un connecteur mâle sur un côté et un connecteur femelle sur le côté opposé de la bande de trois diodes électroluminescentes (2).

6. Dispositif d'éclairage (1) selon l'une des revendications 1 à 5, dans lequel chaque bande de trois diodes électroluminescentes (2) présente un couvercle (5) qui comprend une lentille pour chacune des deux diodes électroluminescentes extérieures (3) et la diode électroluminescente centrale (4).

7. Dispositif d'éclairage (1) selon l'une des revendications 1 à 6, dans lequel chaque bande de trois diodes électroluminescentes (2) présente une lentille totalement réfléchissante.

8. Dispositif d'éclairage (1) selon l'une des revendications 1 à 7, dans lequel les bandes de trois diodes électroluminescentes (2) sont branchées en série sous la forme d'une chaîne de bandes de trois diodes électroluminescentes (2).

9. Dispositif d'éclairage (1) selon l'une des revendications 1 à 8, dans lequel les deux diodes électroluminescentes extérieures (3) et la diode électroluminescente centrale (4) sont choisies indépendamment l'une de l'autre parmi les diodes électroluminescentes ayant une LED bleue et au moins un luminophore.

10. Dispositif d'éclairage (1) selon la revendication 9, dans lequel le luminophore est choisi dans le groupe présentant ou constitué des grenats dopés aux terres rares, y compris le YAG, des thiogallates dopés aux terres rares, des aluminates dopés aux terres rares, des orthosilicates dopés aux terres rares et/ou des oxyorthosilicates dopés aux terres rares.

11. Dispositif d'éclairage (1) selon l'une quelconque des revendications 1 à 10, dans lequel le dispositif d'éclairage (1) présente en outre un circuit de commande sur carte mère et/ou un bloc d'alimentation et/ou un dispositif de réglage.

12. Dispositif d'éclairage selon la revendication 11, dans lequel le dispositif d'éclairage (1) présente un circuit de commande sur carte mère et/ou un bloc d'alimentation électrique et/ou un dispositif de réglage pour chaque bande de trois diodes électroluminescentes (2).

13. Dispositif d'éclairage (1) selon l'une quelconque des revendications 1 à 12, dans lequel le dispositif d'éclairage est une guirlande lumineuse, un dispositif publicitaire lumineux, un espace publicitaire, un feu diurne pour véhicules ou un feu arrière pour véhicules.

A)

B)

C)

Figur 1

Figur 2

Figur 3

Fig. 4

Fig. 5

⊕ 3

⊕ 4

Fig. 6

◈ 5

◈ 6

Fig. 7

⊕ 7

⊕ 8

Fig. 8

⊕ 9

⊕ 10

Fig. 9

Fig. 10

⊕ 13

⊕ 14

Fig. 11

⊕ 15

⊕ 16

Fig. 12

⊕ 17

⊕ 18

Fig. 13

⊕ 19

⊕ 20

Fig. 14

⊕ 21

⊕ 22

Fig. 15

Fig. 16

Fig. 17

⊕ 27

⊕ 28

Fig. 18

⊕ 29

⊕ 30

Fig. 19

Fig. 20

Fig. 21

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2253534 A2
- EP 2378840 A1
- US 2005135094 A1
- US 2011031894 A1
- US 20012300452 A1
- WO 2012104800 A2
- US 2010296269 A1